# EUROPÄISCHE PATENTSCHRIFT

(11) **EP 3 717 495 B1**
(45) Veröffentlichungstag und Bekanntmachung des Hinweises auf die Patenterteilung: **29.12.2021**
(21) Anmeldenummer: 18800630.8
(22) Anmeldetag: 09.11.2018
(51) Int. Cl.: C07F 15/00, H01L 51/00, H01L 51/50

(54) **PHOSPHORESZENTE ANHC-BASIERTE PLATIN(II)-KOMPLEXE**
PHOSPHORESCENT PLATINUM (II) ANHC COMPLEXES
COMPLEXES DE PLATINE (II) PHOSPHORESCENTS À BASE DE ANHC

(30) Priorität: 01.12.2017 DE 102017128629
(43) Veröffentlichungstag der Anmeldung: 07.10.2020
(73) Patentinhaber: Technische Universität Dresden, 01062 Dresden (DE)
(72) Erfinder: SÖLLNER, Johannes, 01159 Dresden (DE); STRAßNER, Thomas, 01156 Dresden (DE)
(74) Vertreter: Trösch, Dominique
(86) Internationale Anmeldenummer: PCT/EP2018/080790
(87) Internationale Veröffentlichungsnummer: WO 2019/105720

(56) Entgegenhaltungen:
- WO-A2-2011/050003

## Beschreibung

Die vorliegende Erfindung betrifft Platin(II)-Komplexe mit N-heterocyclischen CarbenLiganden (NHC-Liganden), Organische Leuchtdioden (OLEDs) enthaltend mindestens einen entsprechenden Komplex, eine Vorrichtung wie beispielsweise einen stationären oder mobilen Bildschirm oder ein Beleuchtungsmittel, die eine entsprechende OLED enthält, sowie die Verwendung der vorgenannten Komplexe in OLEDs, beispielsweise als Emitter, Matrixmaterial, Ladungstransportmaterial, und/oder Ladungsblocker.

In OLEDs wird die Eigenschaft von Materialien ausgenutzt, Licht zu emittieren, wenn diese Materialien durch elektrischen Strom angeregt werden. Insbesondere sind OLEDs als Alternative zu Kathodenstrahlröhren und Flüssigkristalldisplays zur Herstellung von Flachbildschirmen interessant. Aufgrund der sehr kompakten Bauweise und des intrinsisch niedrigen Stromverbrauchs eignet sich die Vorrichtung enthaltend OLEDs insbesondere für mobile Anwendungen, z. B. für Anwendungen in Mobiltelefonen, Laptops usw., sowie zur Beleuchtung.

Der Stand der Technik offenbart eine Vielzahl von Materialien, die Licht emittieren, wenn sie durch elektrischen Strom angeregt werden, darunter auch Platin(II)-Komplexe mit NHC-Liganden. Bei den aus dem Stand der Technik bekannten Platin(II)-Komplexen mit NHC-Liganden, die einen Imidazol- bzw. Imidazolylidring aufweisen, befindet sich das CarbenKohlenstoffatom an Ringatom 2 des Imidazolringes, d.h. zwischen zwei Stickstoffatomen im Imidazol-Ringsystem des NHC-Liganden, siehe A. Tronnier, S. Metz, G. Wagenblast, I. Muenster, T. Strassner, Dalton Trans. 2014, 43, 3297.

Vereinzelt gibt es Übergangsmetallkomplexe mit sogenannten abnormal bindenden N-heterozyclischen Carbenliganden (aNHC-Liganden). In Hota et al., Adv. Synth. Catal. 2015, 357, 3162-3170 ist ein zweikerniger bzw. dimerer Palladium-Komplex und dessen Einsetzbarkeit als Katalysator in der Heck-Reaktion beschrieben. Vijaykumar et al., Organometallics 2017, 36, 4753-4758 beschreiben mit aNHC-Liganden versehene Nickelkatalysatoren für die Hydroheteroarylierung von Vinylarenen. WO 2011/050003 A2 beschreibt einen Platin-Komplex mit einem dreizähnigen pincer-Liganden, bei dem zwei der "Zähne" durch aNHC-Ligand-Gruppen gebildet werden. So bleibt im Fall von Platin als Zentralatom lediglich Platz für einen einzähnigen Liganden.

Aufgabe der Erfindung ist, alternative Platin(II)-Komplexe mit NHC-Liganden zur Verfügung zu stellen, die zur Verwendung in OLEDs, insbesondere als Emitter bzw. als lichtemittierende Substanzen geeignet sind.

Die vorstehende Aufgabe wird gelöst durch einen Platin(II)-Komplex der folgenden Formel (I) 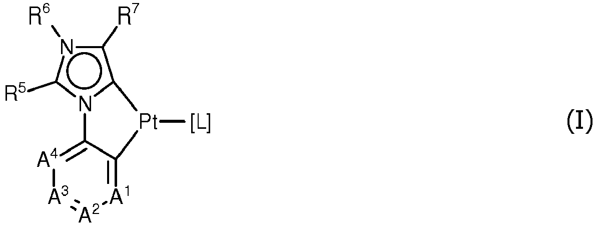 wobei
- A¹ N oder CR¹ ist,
- A² N oder CR² ist,
- A³ N oder CR³ ist,
- A⁴ N oder CR⁴ ist,
- R¹ bis R⁴ jeweils unabhängig voneinander ausgewählt sind aus H, einem linearen oder verzweigten, substituierten oder nicht substituierten Alkylrest mit 1 bis 20 Kohlenstoffatomen, in dem gegebenenfalls mindestens ein Kohlenstoffatom durch ein Heteroatom ersetzt ist, einem substituierten oder nicht substituierten Cycloalkylrest mit 3 bis 20 Kohlenstoffatomen, in dem gegebenenfalls mindestens ein Kohlenstoffatom durch ein Heteroatom ersetzt ist, einem substituierten oder nicht substituierten Arylrest mit 6 bis 30 Kohlenstoffatomen, einem substituierten oder nicht substituierten Heteroarylrest mit 5 bis 18 Kohlenstoff- und/oder Heteroatomen, oder einer Gruppe mit Akzeptor- oder Donoreigenschaften, oder R¹ und R², R² und R³, und/oder R³ und R⁴ gemeinsam mit den Atomen, an die sie gebunden sind, ein kondensiertes aromatisches Ringsystem mit 5 bis 18 Kohlenstoff- und/oder Heteroatomen bilden, wobei das kondensierte aromatische Ringsystem substituiert ist oder nicht substituiert ist,
- R⁵ und R⁶ jeweils unabhängig voneinander ausgewählt sind aus einem linearen oder verzweigten, substituierten oder nicht substituierten Alkylrest mit 1 bis 20 Kohlenstoffatomen, in dem gegebenenfalls mindestens ein Kohlenstoffatom durch ein Heteroatom ersetzt ist, einem substituierten oder nicht substituierten Cycloalkylrest mit 3 bis 20 Kohlenstoffatomen, in dem gegebenenfalls mindestens ein Kohlenstoffatom durch ein Heteroatom ersetzt ist, einem substituierten oder nicht substituierten Arylrest mit 6 bis 30 Kohlenstoffatomen, einem substituierten oder nicht substituierten Heteroarylrest mit 5 bis 18 Kohlenstoff- und/oder Heteroatomen, oder einer Gruppe mit Akzeptor- oder Donoreigenschaften, und
- R⁷ ausgewählt ist aus H, einem linearen oder verzweigten, substituierten oder nicht substituierten Alkylrest mit 1 bis 20 Kohlenstoffatomen, in dem gegebenenfalls mindestens ein Kohlenstoffatom durch ein Heteroatom ersetzt ist, einem substituierten oder nicht substituierten Cycloalkylrest mit 3 bis 20 Kohlenstoffatomen, in dem gegebenenfalls mindestens ein Kohlenstoffatom durch ein Heteroatom ersetzt ist, einem substituierten oder nicht substituierten Arylrest mit 6 bis 30 Kohlenstoffatomen, einem substituierten oder nicht substituierten Heteroarylrest mit 5 bis 18 Kohlenstoff- und/oder Heteroatomen, oder einer Gruppe mit Akzeptor- oder Donoreigenschaften, oder
- R⁵ und R⁶ oder R⁶ und R⁷ gemeinsam mit den Atomen, an die sie gebunden sind, ein kondensiertes aromatisches Ringsystem mit 5 bis 18 Kohlenstoff- und/oder Heteroatomen bilden, wobei das kondensierte aromatische Ringsystem substituiert ist oder nicht substituiert ist,
- oder R⁴ und R⁵ gemeinsam mit den Atomen, an die sie gebunden sind, ein kondensiertes aromatisches Ringsystem mit 6 bis 18 Kohlenstoff- und/oder Heteroatomen bilden, wobei das kondensierte aromatische Ringsystem substituiert ist oder nicht substituiert ist,
- L ein zweizähniger monoanionischer Ligand ist, und
wobei
R¹ bis R⁷ und L jeweils gegebenenfalls eine oder mehrere funktionelle Gruppen mit Donor- oder Akzeptoreigenschaften tragen.

Im Sinne der vorliegenden Erfindung haben Begriffe wie Arylrest, Heteroarylrest, kondensiertes aromatisches Ringsystem, Alkylrest, "substituiert" und andere die folgenden Bedeutungen:
Arylrest: Ein Arylrest oder eine Arylgruppe ist ein Rest mit einem Grundgerüst von 6 bis 30 Kohlenstoffatomen, bevorzugt 6 bis 18 Kohlenstoffatomen, der aus einem aromatischen Ring oder mehreren kondensierten aromatischen Ringen aufgebaut ist. Geeignete Grundgerüste sind zum Beispiel Phenyl, Naphthyl, Anthracenyl oder Phenanthrenyl. Dieses Grundgerüst kann unsubstituiert sein, d. h., dass alle Kohlenstoffatome, die substituierbar sind, Wasserstoffatome tragen, oder an einer, mehreren oder allen substituierbaren Positionen des Grundgerüsts substituiert sind.

Bevorzugt ist der Arylrest oder die Arylgruppe ein C₆-Arylrest, der gegebenenfalls mit mindestens einem der nachstehend genannten Substituenten substituiert ist. Besonders bevorzugt weist der C₆-Arylrest keinen, einen, zwei, drei oder vier der nachstehend genannten Substituenten auf.

"Substituiert": Substituiert bedeutet, dass ein oder mehrere Wasserstoffatome durch andere Substituenten ersetzt wurden. Geeignete Substituenten sind zum Beispiel Alkylreste, bevorzugt Alkylreste mit 1 bis 8 Kohlenstoffatomen, besonders bevorzugt Methyl, Ethyl, i-Propyl oder t-Butyl, Arylreste, bevorzugt C₆-Arylreste, die wiederum substituiert oder unsubstituiert sein können, Heteroarylreste, bevorzugt Heteroarylreste, die mindestens ein Stickstoffatom enthalten, besonders bevorzugt Pyridylreste, Alkenylreste, bevorzugt Alkenylreste, die eine Doppelbindung tragen, besonders bevorzugt Alkenylreste mit einer Doppelbindung und 1 bis 8 Kohlenstoffatomen, oder (funktionelle) Gruppen mit Donor- oder Akzeptorwirkung bzw. - eigenschaften. Ganz besonders bevorzugt tragen die Arylreste Substituenten ausgewählt aus der Gruppe bestehend aus Alkylen, insbesondere Methyl (-CH₃), F, disubstituierte Aminreste (-NR₂), Thiogruppen (-SR) und Alkoxygruppen (-OR).

(Funktionelle) Gruppen mit Donor- oder Akzeptorwirkung bzw. -eigenschaften: Unter Gruppen mit Donorwirkung bzw. Donoreigenschaften sind Gruppen zu verstehen, die einen positiven induktiven (+I) und/oder positiven mesomeren (+M) Effekt aufweisen, und unter Gruppen mit Akzeptorwirkung bzw. Akzeptoreigenschaften sind Gruppen zu verstehen, die einen negativen induktiven (-I) und/oder negativen mesomeren (-M) Effekt aufweisen. Geeignete Gruppen mit Donor- oder Akzeptorwirkung sind Halogenreste, bevorzugt F, CI, Br, besonders bevorzugt F, Alkoxyreste, Aryloxyreste, Carbonylreste (-C(O)R), Esterreste (-COOR), Aminreste (-NH₂, -NHR, -NR₂), Amidreste, CH₂F-Gruppen, CHF₂-Gruppen, CF₃-Gruppen, CN-Gruppen, NC-Gruppen, Thiogruppen, SCN-Gruppen, NCS-Gruppen, die Nitro- oder NO₂-Gruppe, Bordiorganylgruppen -BR₂, sowie Diorganylphosphangruppen -PR₂, wobei R jeweils für einen beliebigen organischen Rest steht.

Heteroarylrest: Ein Heteroarylrest oder eine Heteroarylgruppe ist ein Rest, der sich von den vorstehend genannten Arylresten dadurch unterscheiden, dass in dem Grundgerüst des Arylrestes mindestens ein Kohlenstoffatom durch ein Heteroatom ersetzt ist. Bevorzugte Heteroatome sind N, O und S. Ganz besonders bevorzugt sind ein oder zwei Kohlenstoffatome des Grundgerüsts des Arylrests durch Heteroatome ersetzt. Insbesondere bevorzugt ist das Grundgerüst ausgewählt aus Pyridyl, Pyrimidyl, Pyrazyl, Triazyl, und fünfgliedrigen Heteroaromaten wie Pyrrol, Furan, Thiophen, Pyrazol, Imidazol, Triazol, Oxazol, Thiazol. Das Grundgerüst kann an keiner, einer, mehreren oder allen substituierbaren Positionen des Grundgerüsts substituiert sein.

Kondensiertes aromatisches Ringsystem: Ein kondensiertes aromatisches Ringsystem ist ein Rest mit einem Grundgerüst von 6 bis 30 Kohlenstoffatomen, bevorzugt 6 bis 18 Kohlenstoffatomen, der aus einem aromatischen Ring oder mehreren kondensierten aromatischen Ringen aufgebaut ist. Geeignete Grundgerüste sind zum Beispiel Phenyl, Naphtyl, Anthracenyl oder Phenanthrenyl. Dieses Grundgerüst kann unsubstituiert sein, d. h., dass alle Kohlenstoffatome, die substituierbar sind, Wasserstoffatome tragen, oder an einer, mehreren oder allen substituierbaren Positionen des Grundgerüsts substituiert sind.

Alkylrest: Ein Alkylrest oder eine Alkylgruppe ist ein Rest mit 1 bis 20 Kohlenstoffatomen, bevorzugt 1 bis 10 Kohlenstoffatomen, besonders bevorzugt 1 bis 8 Kohlenstoffatomen. Dieser Alkylrest kann verzweigt oder unverzweigt sein und gegebenenfalls mit einem oder mehreren Heteroatomen, bevorzugt N, O oder S, unterbrochen sein. Des Weiteren kann dieser Alkylrest mit einem oder mehreren oben im Zusammenhang mit den Arylgruppen genannten Substituenten substituiert sein. Der Alkylrest kann auch eine oder mehrere Arylgruppen tragen. Dabei sind alle der vorstehend aufgeführten Arylgruppen geeignet. Besonders bevorzugt sind die Alkylreste ausgewählt aus der Gruppe bestehend aus Methyl, Ethyl, i-Propyl, n-Propyl, i-Butyl, n-Butyl, t-Butyl, sec-Butyl, i-Pentyl, n-Pentyl, sec-Pentyl, neo-Pentyl, n-Hexyl, Hexyl und sec-Hexyl. Ganz besonders bevorzugt sind Methyl, i-Propyl, tert-Butyl und n- Hexyl, insbesondere Methyl.

Cycloalkylrest: Unter einem Cycloalkylrest oder einer Cycloalkylgruppe ist ein mono-, di- oder tricyclischer Rest mit 3 bis 20 Kohlenstoffatomen, bevorzugt 3 bis 10 Kohlenstoffatomen, besonders bevorzugt 3 bis 8 Kohlenstoffatomen zu verstehen. Dieser Cycloalkylrest kann gegebenenfalls mit einem oder mehreren Heteroatomen, bevorzugt N, O oder S unterbrochen sein. Der Cycloalkylrest kann unsubstituiert oder substituiert sein, d. h. mit einem oder mehreren der bezüglich der Arylgruppen genannten Substituenten substituiert sein. Es ist ebenfalls möglich, dass der Cycloalkylrest eine oder mehrere Arylgruppen trägt. Dabei sind alle der vorstehend aufgeführten Arylgruppen geeignet.

A¹ bis A⁴ können jeweils unabhängig voneinander N bedeuten, auch mehrere von A¹ bis A⁴ können N bedeuten, wobei in diesem Fall bevorzugt A¹ und/oder A³ N bedeuten.

Zwei oder mehr der Reste R¹ bis R⁴, die benachbart sind, können gemeinsam mit den Atomen, an die sie gebunden sind, ein kondensiertes aromatisches Ringsystem bilden, so dass der zweizähnige NHC-Ligand des erfindungsgemäßen Pt(II)-Komplexes beispielsweise eine Benzofuryl-, Benzothiophenyl-, Dibenzofuryl-, Dibenzothiophenyl-, Naphtyl-, Anthracenyl-, Phenanthrenyl-, Fluorenyl- oder auch eine Carbazolgruppe umfasst, wie anhand der folgenden beispielhaften Formeln 1 - 27 ersichtlich wird.

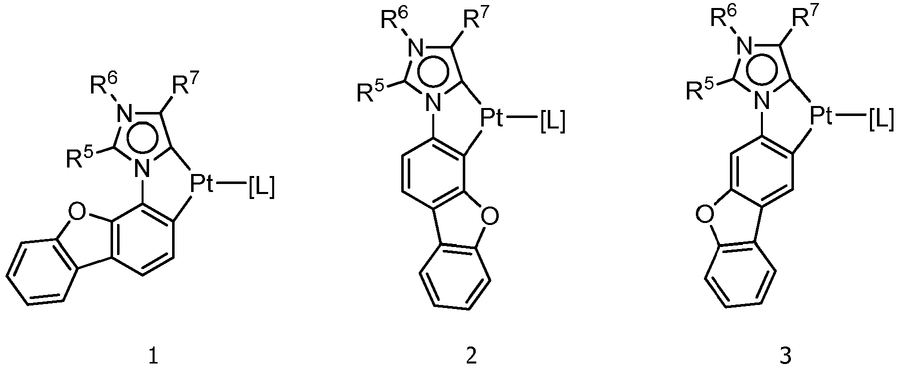

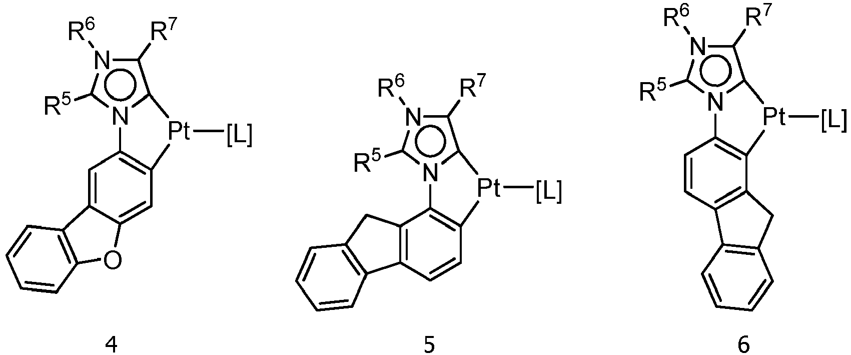

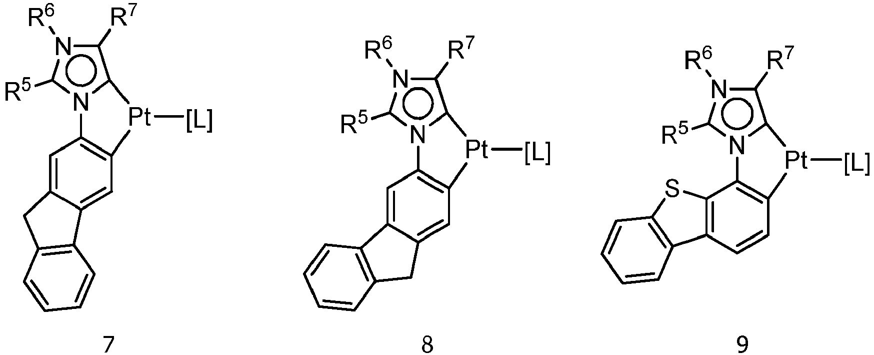

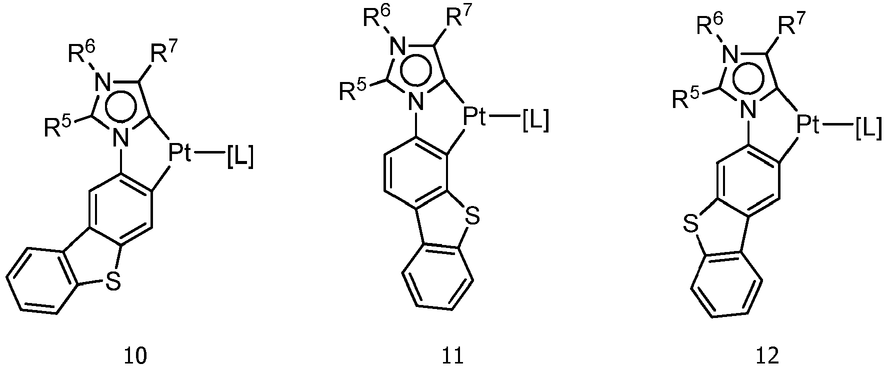

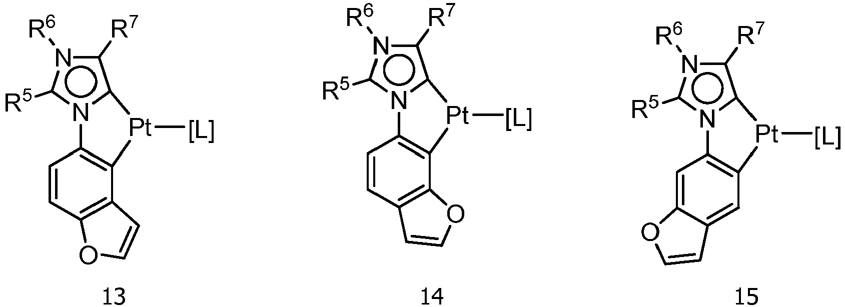

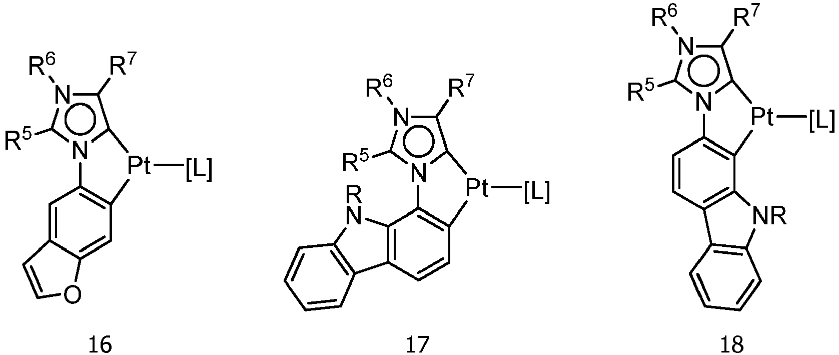

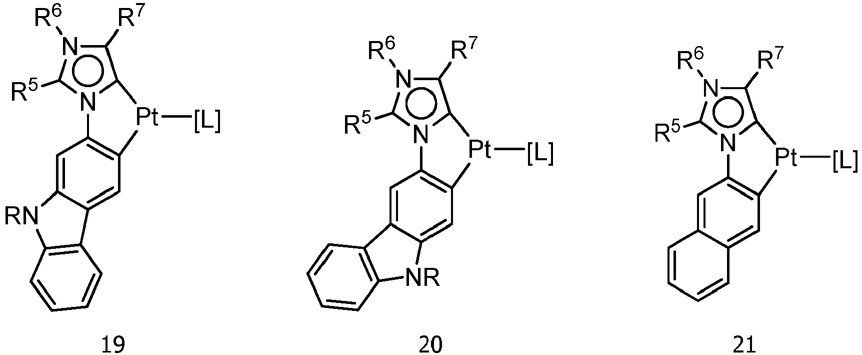

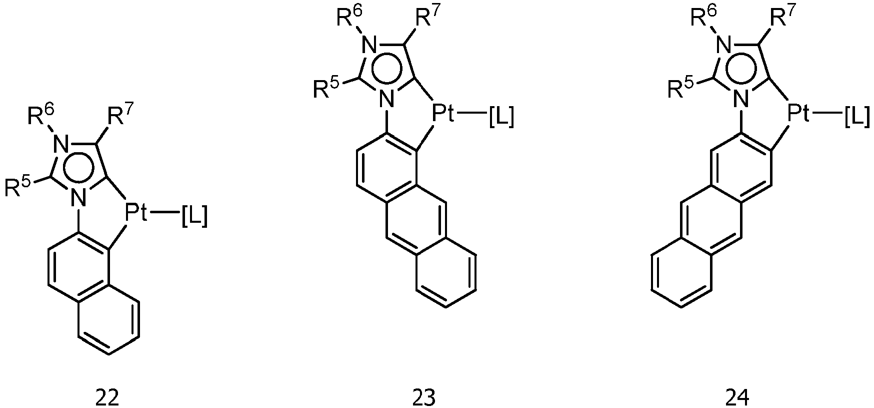

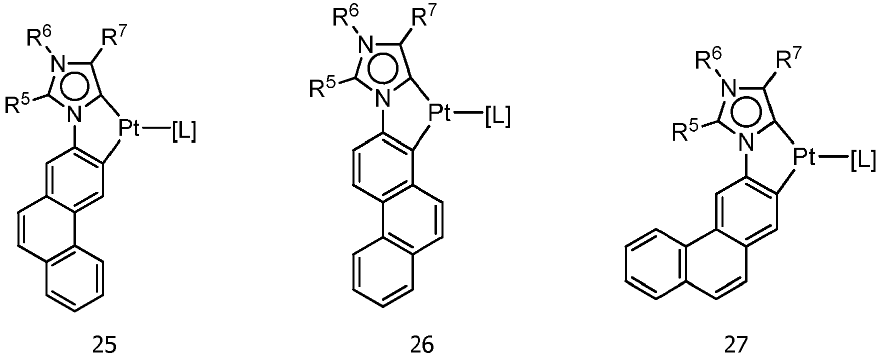

In den vorstehenden Formeln stellen dar:
- Die Formeln 1 bis 4 verschiedene mögliche Isomere erfindungsgemäßer Komplexe mit einer Dibenzofurangruppe,
- die Formeln 5 bis 8 verschiedene mögliche Isomere erfindungsgemäßer Komplexe mit einer Fluorengruppe,
- die Formeln 9 bis 12 verschiedene mögliche Isomere erfindungsgemäßer Komplexe mit einer Dibenzothiofurangruppe,
- die Formeln 13 bis 16 verschiedene mögliche Isomere erfindungsgemäßer Komplexe mit einer Benzofurangruppe,
- die Formeln 17 bis 20 verschiedene mögliche Isomere erfindungsgemäßer Komplexe mit einer Carbazolgruppe,
- die Formeln 21 bis 22 verschiedene mögliche Isomere erfindungsgemäßer Komplexe mit einer Naphtalingruppe,
- die Formeln 23 bis 24 verschiedene mögliche Isomere erfindungsgemäßer Komplexe mit einer Anthracenylgruppe, und
- die Formeln 25 bis 27 verschiedene mögliche Isomere erfindungsgemäßer Komplexe mit einer Phenanthrengruppe.

Die Formeln 1 bis 27 dienen lediglich der Veranschaulichung und sind nicht einschränkend auszulegen. So sind weitere kondensierte aromatische Gruppen denkbar, die ebenfalls in Form unterschiedlicher Isomere vorliegen. Insbesondere können, wie oben angeführt, die kondensierten aromatischen Ringsysteme substituiert sein. Als Substituenten sind alle vorstehend bereits genannten Substituenten geeignet, insbesondere Substituenten mit Donor- oder Akzeptorwirkung.

R⁷ kann H sein. Das ist vorteilhaft, weil dann der weitere zweizähnige monoanionische Ligand [L] einen größeren Raumbedarf einnehmen kann.

In den erfindungsgemäßen Komplexen ist das eine Bindung zu Platin eingehende Carbenkohlenstoffatom des NHC-Liganden ein Ringatom des Imidazolrings. Das Carbenkohlenstoffatom ist somit benachbart zu je einem Stickstoffatom und einem Kohlenstoffatom. Der Imidazolring in den erfindungsgemäßen Komplexen hat mesoionischen Charakter, d.h. es lässt sich für den Imidazolring keine neutrale mesomere Grenzstruktur formulieren:

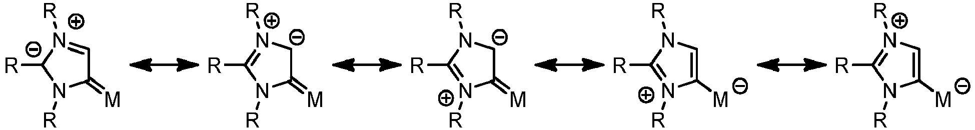

Der mesoionische Charakter bedeutet eine gegenüber entsprechenden Platinkomplexen mit herkömmlichen NHC-Liganden veränderte Verteilung der Elektronen am NHC-Liganden. Die erfindungsgemäßen Komplexe stellen somit eine neue Verbindungsklasse dar, die sich insbesondere für eine Verwendung in OLEDs eignen.

[L] ist erfindungsgemäß ein zweizähniger monoanionischer Ligand. Der zweizähnige Ligand [L] bindet aufgrund seiner Zweizähnigkeit zweifach an das Zentralatom. Die erfindungsgemäßen Platin(II)-Komplexe haben somit zwei zweizähnige Liganden, sind grundsätzlich vierbindig und im Wesentlichen quadratisch planar.

Der Ligand L kann vorteilhaft und bevorzugt ein zweizähniger monoanionischer Ligand der Formel (II) sein: 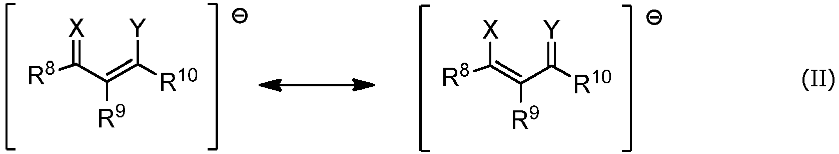 wobei
- X und Y unabhängig voneinander ausgewählt sind aus O, S oder NR¹¹,
- R⁸ und R¹⁰ unabhängig voneinander ausgewählt sind aus einem linearen oder verzweigten, substituierten oder nicht substituierten Alkylrest mit 1 bis 20 Kohlenstoffatomen, in dem gegebenenfalls mindestens ein Kohlenstoffatom durch ein Heteroatom ersetzt ist, einem substituierten oder nicht substituierten Cycloalkylrest mit 3 bis 20 Kohlenstoffatomen, in dem gegebenenfalls mindestens ein Kohlenstoffatom durch ein Heteroatom ersetzt ist und der gegebenenfalls eine oder mehrere funktionelle Gruppen trägt, einem substituierten oder nicht substituierten Arylrest mit 6 bis 30 Kohlenstoffatomen, einem substituierten oder nicht substituierten Heteroarylrest mit 5 bis 18 Kohlenstoff- und/oder Heteroatomen,
- R⁹ und R¹¹ jeweils unabhängig voneinander ausgewählt sind aus
   H, einem linearen oder verzweigten, substituierten oder nicht substituierten Alkylrest mit 1 bis 20 Kohlenstoffatomen, in dem gegebenenfalls mindestens ein Kohlenstoffatom durch ein Heteroatom ersetzt, einem substituierten oder nicht substituierten Cycloalkylrest mit 3 bis 20 Kohlenstoffatomen, in dem gegebenenfalls mindestens ein Kohlenstoffatom durch ein Heteroatom ersetzt ist, einem substituierten oder nicht substituierten Arylrest mit 6 bis 30 Kohlenstoffatomen, einem substituierten oder nicht substituierten Heteroarylrest mit 5 bis 18 Kohlenstoff- und/oder Heteroatomen, oder
- R⁸ und R⁹, R⁹ und R¹⁰, oder R⁸ und R¹¹ und/oder R¹⁰ und R¹¹ gemeinsam mit den Atomen, an die sie gebunden sind, ein kondensiertes aromatisches Ringsystem mit 5 bis 18 Kohlenstoff- und/oder Heteroatomen bilden, wobei das kondensierte aromatische Ringsystem substituiert ist oder nicht substituiert ist, wobei
R⁸ bis R¹¹ jeweils gegebenenfalls eine oder mehrere funktionelle Gruppen mit Donor- oder Akzeptoreigenschaften tragen, und wobei,
wenn sowohl X als auch Y NR¹¹ sind, die beiden Reste R¹¹ identisch oder nicht identisch sind.

In Liganden der vorangestellten Formel (II) sind X und Y vorteilhaft und bevorzugt gleich, besonders bevorzugt jeweils NR¹¹ oder O.

In Liganden der vorangestellten Formel (II)sind R⁸ und R¹⁰ vorteilhaft und bevorzugt jeweils unabhängig voneinander ausgewählt aus der Gruppe bestehend aus Methyl, tert.-Butyl, Mesityl, Duryl, wobei Mesityl (2,4,6-Trimethylphenyl) und Duryl (2,3,5,6-Tetramethylphenyl) besonders bevorzugt sind.

Besonders vorteilhaft und bevorzugt ist der Ligand [L] der Formel (II) symmetrisch in dem Sinne aufgebaut, dass sowohl X und Y als auch R⁸ und R¹⁰ identisch sind.

Vorteilhaft und bevorzugt können A¹ bis A⁴ CR¹ bis CR⁴ sein, wobei mindestens zwei von R¹ bis R⁴ gemeinsam mit den Atomen, an die sie gebunden sind, ein kondensiertes aromatisches Ringsystem bilden.

Ferner sind erfindungsgemäße Platin(II)-Komplexe bevorzugt, bei denen R⁷ H ist.

Ganz besonders bevorzugt sind A¹ bis A⁴ jeweils CR¹ bis CR⁴,
R¹, R², R³, R⁴, R⁷, R⁹ jeweils H,
ist R⁵ ausgewählt aus der Gruppe bestehend aus Phenyl, 4-Bromphenyl, 4-Cyanophenyl,
ist R⁶ ausgewählt aus der Gruppe bestehend aus Methyl oder Phenyl, und sind R⁸, R¹⁰ jeweils unabhängig voneinander ausgewählt aus der Gruppe bestehend aus Methyl, tert.-Butyl, Mesityl, Duryl, wobei Mesityl und Duryl noch weiter bevorzugt sind.

Bevorzugte erfindungsgemäße Platin(II)-Komplexe sind außerdem folgende Einzelverbindungen:

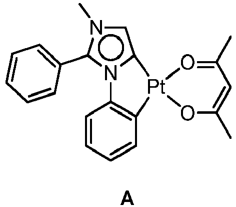

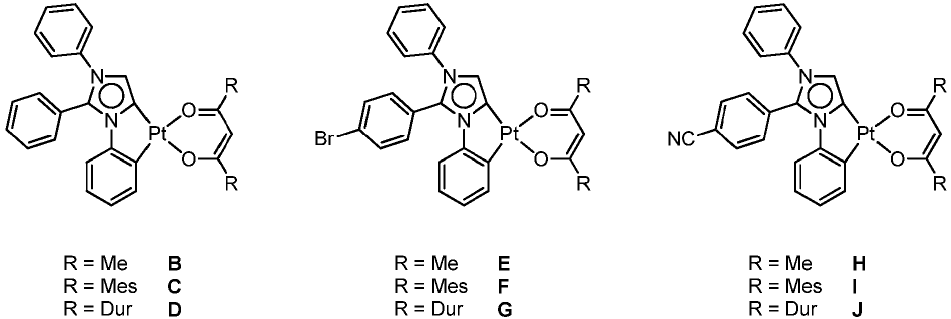

Die erfindungsgemäßen Komplexe sind besonders als Emittermoleküle in OLEDs geeignet. Insbesondere ist es möglich, entsprechende Komplexe bereit zu stellen, die Elektrolumineszenz in allen sichtbaren Bereichen, insbesondere im blauen Bereich des elektromagnetischen Spektrums zeigen. Die erfindungsgemäßen Komplexe eignen sich darum für den Einsatz in technisch verwendbaren Vollfarbendisplays oder weißen OLEDs als Beleuchtungsmittel.

Weitere Gegenstände der Erfindung sind demgemäß
- eine OLED, die mindestens einen erfindungsgemäßen Platin(II)-Komplex enthält,
- eine Licht emittierende Schicht, die mindestens einen erfindungsgemäßen Platin(II)-Komplex enthält,
- eine OLED, die mindestens eine erfindungsgemäße Licht emittierende Schicht enthält,
- eine Vorrichtung, die eine erfindungsgemäße OLED und/oder eine erfindungsgemäße Licht emittierende Schicht enthält,
- eine Verwendung eines erfindungsgemäßen Platin(II)-Komplexes in einer OLED, und
- eine Verwendung eines erfindungsgemäßen Platin(II)-Komplexes in einer OLED, wobei der Platin(II)-Komplex als Emitter, Matrixmaterial, Ladungstransportmaterial, und/oder Ladungsblocker eingesetzt wird.

Grundsätzlich sind OLEDs aus mehreren Schichten aufgebaut, nämlich (i) Anode, (ii) Löcher transportierende Schicht, (iii) Licht emittierende Schicht, (iv) Elektronen transportierende Schicht, (v) Kathode. Erfindungsgemäße OLED können zusätzlich weitere Schichten enthalten, die dem Fachmann bekannt sind.

Die erfindungsgemäßen Metall-Carben-Komplexe werden bevorzugt als Emittermoleküle in der Licht emittierenden Schicht (iii) eingesetzt.

Der Fachmann ist in der Lage, den Aufbau der OLEDs so zu wählen, dass er optimal an die erfindungsgemäßen Komplexe und ihren konkreten Einsatz, bevorzugt als Emitter, in der OLED angepasst ist.

Die erfindungsgemäßen OLEDs können in allen Vorrichtungen eingesetzt werden, worin Elektrolumineszenz nützlich ist.

Entsprechende Vorrichtungen sind stationäre Bildschirme, wie z. B. Bildschirme von Computern, Fernsehern, Bildschirme in Druckern, Küchengeräten sowie Reklametafeln, Beleuchtungen und Hinweistafeln. Mobile Bildschirme sind z.B. Bildschirme in Handys, Laptops, Fotokameras, Fahrzeugen sowie Zielanzeigen an Bussen und Bahnen.

Zur Herstellung erfindungsgemäßer Platin(II)-Komplexe eigenen sich Verfahren zur Herstellung erfindungsgemäßer Platin(II)-Komplexe mittels Inkontaktbringen geeigneter Platin-Verbindungen mit entsprechenden Liganden bzw. Ligandvorstufen.

Die Liganden sind einerseits der NHC-Ligand, andererseits monoanionische zweizähnige Liganden [L], oder deren jeweilige Vorstufen.

Als geeignete Platin-Verbindungen im Allgemeinen sind alle dem Fachmann bekannten Pt-Salze bzw. -Komplexe geeignet, die unter den erfindungsgemäßen Reaktionsbedingungen eine genügend hohe Reaktivität zeigen. Bevorzugt sind entsprechende Pt-Salze bzw.-Komplexe ausgewählt aus der Gruppe bestehend aus Pt(COD)Cl₂ (COD = Cyclooctadien), Pt(PPh₃)₂Cl₂, Pt(Pyridin)₂Cl₂, Pt(NH₃)₂Cl₂, Pt(acac)₂, PtCl₂, K₂PtCl₄ und Mischungen davon. Besonders bevorzugt wird Pt(COD)Cl₂ eingesetzt.

Geeignete NHC-Liganden sind Verbindungen, die nach Reaktion mit Pt-Verbindungen die Metall-Carben-Komplexe der o.a. allgemeinen Formel (I) ergeben.

Geeignete NHC-Liganden können in Form von Salzen der folgenden allgemeinen Formel (III) eingesetzt werden 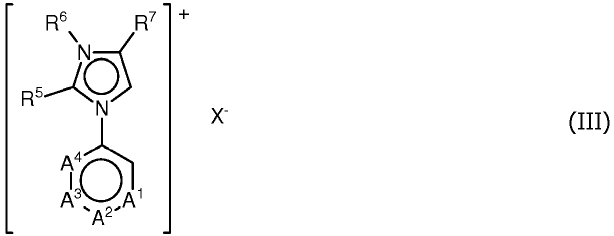
worin A¹ bis A⁴ und R¹ bis R⁷ die gleichen Bedeutungen haben wie oben im Zusammenhang mit Formel (I) beschrieben, und
X⁻ ein Anion bedeutet, wie beispielsweise ein Halogenid-Ion, insbesondere Cl⁻, Br⁻, I⁻, besonders bevorzugt I⁻, oder BF₄⁻, PF₆⁻, N(SO₂CF₃)₂⁻, SbF₆⁻,ClO₄⁻, ½ SO₄²⁻ , bevorzugt BF₄⁻ oder PF₆⁻, besonders bevorzugt BF₄⁻.

Besonders bevorzugte Verbindungen der allgemeinen Formel (III), die in erfindungsgemäßen Verfahren als Ligandvorläufer eingesetzt werden, sind solche, welche die oben genannten bevorzugten Reste R¹, R², R³, R⁴, R⁵, R⁶, R⁷ enthalten, und insbesondere solche, in denen X⁻BF₄⁻ oder I⁻ ist.

Dem Fachmann stehen verschiedene Methoden zur Verfügung, um entsprechend substituierte Imidazolringe aufzubauen.

Um erfindungsgemäße Komplexe herzustellen, wird zunächst zum Beispiel ausgehend von einem aromatischen Amin ein entsprechend 1,2-substituiertes Imidazol aufgebaut. Beispielsweise kann das aromatische Amin (z.B. Anilin), durch Reaktion mit einem entsprechend substituierten aromatischen Nitril (z.B. Benzonitril) im Beisein eines Base wie Natriumhydrid zu einem Amidin (z.B. N-Phenylbenzamidin im Fall der Reaktion von Anilin mit Benzonitril) umgesetzt werden. Als Lösungsmittel eignet sich beispielsweise DMSO; außer dem beispielhaft erwähnten Anilin und dem beispielhaft erwähnten Benzonitril können eine Vielzahl anderer aromatischer Amine und Nitrile bei dieser Reaktion eingesetzt werden, darunter auch substituierte aromatische Amine und Nitrile.

Das resultierende Amidin kann mit Chloracetaldehyd, beispielsweise durch Lösen in Trichlormethan und 24h Erwärmen auf 70°C, zu einem entsprechend 1,2-substituierten 1H-Imidazol umgesetzt werden (im Fall von N-Phenylbenzamidin beispielsweise zu 1,2-Diphenyl-1H-imidazol).

1,2-disubstituierte 1H-Imidazole lassen sich auch auf andere Weise darstellen, beispielsweise mittels Reaktion von Glyoxal mit einem Aldehyd und einem aromatischen Amin in Beisein von Ammoniak bzw. eines Ammoniumsalzes, wie beispielsweise beschrieben in einer Vielzahl von Referenzbeispielen in EP 2 254 871 B1 oder allgemein in US 6 177 575.

Dem Fachmann sind weitere Synthesemöglichkeiten bekannt.

Ein 1,2-disubstituiertes 1H-Imidazol lässt sich durch Behandlung beispielsweise mit einem Alkyliodid oder einer anderweitigen geeigneten Verbindung, wie beispielweise einem Diaryliodoniumsalz, am Ringatom 3 (Stickstoff) des Imidazolrings mit dem gewünschten Rest, beispielsweise mit einer Methylgruppe (durch Reaktion mit Methyliodid) oder einer substituierten oder unsubstituierten Arylgruppe (z.B. durch Reaktion mit einem entsprechenden Diaryliodoniumsalz) versehen, wobei das Produkt ein Salz der o.a. allgemeinen Formel (III) mit einem entsprechenden Gegenion (beispielsweise Iodid oder Tetrafluoroborat) ist.

Verschieden substituierte Diaryliodoniumsalze sind z.B. beschrieben in Marcin Bielawski, Diaryliodonium Salts, Stockholm 2012 (ISBN: 978-91-7447-233-2, m.w.N.). Im Beisein von Kupfer(II)-acetatmonohydrat können zum Beispiel entsprechende Diaryliodoniumtetrafluoroborate unter Rühren bei 100°C in DMF mit den o.a. 1,2-disubstituierten 1H-Imidazolen verwendet werden, um 1,2,3-trisubstituierte Imidazole in Form von Imidazoliumsalzen bereit zu stellen, beispielsweise 1,2,3-Triphenyl-1H-imididazoliumtetrafluoroborat. Die Verwendung von Diaryliodoniumsalzen gestattet die Einführung ganz verschieden substituierter Arylgruppen an Ringatom 3 (Stickstoff) des Imidazolrings.

Die resultierende Verbindung der Formel (III) wird dann beispielsweise im Beisein von Silber(I)-oxid in DMF bei 75° C 23 h gerührt, bevor sie mit einer geeigneten, Platin enthaltenden Vorstufe (beispielsweise Pt(COD)Cl₂) zunächst bei Raumtemperatur (z.B. 3 h) und dann bei 120-130°C (z.B. 21 h) umgesetzt wird. Anschließendes Umsetzen mit der Vorstufe für den zweiten, monoanionischen zweizähnigen Liganden, beispielsweise Acetylaceton, und Kaliumcarbonat, gefolgt von Rühren bei Raumtemperatur (z.B. 21 h) und anschließend bei 100° C (z.B. 6 h) ergibt erfindungsgemäße Komplexe der o.a. Formel (I).

Das molare Verhältnis der Edukte in dem erfindungsgemäßen Verfahren wird so bemessen, dass entsprechende Verbindungen der allgemeinen Formel (I) erhalten werden, beispielsweise 1 bis 10 eq., bevorzugt 1 bis 5 eq., besonders bevorzugt 1 bis 2 eq. NHC-Ligandvorstufe der Formel (III), 1 eq. Platin-Verbindung, ½ eq. Silber(I)-oxid, und 1 bis 10 eq., bevorzugt jeweils 1 bis 5 eq., besonders bevorzugt jeweils 2 bis 4 eq. Ligandvorstufe des monoanionischen zweizähnigen Liganden L und Kaliumcarbonat.

Bevorzugt wird das erfindungsgemäße Verfahren in einem Lösungsmittel durchgeführt. Geeignete Lösungsmittel sind dem Fachmann bekannt, beispielsweise Ether, cyclische Ether, Ketone, polare Lösungsmittel, bevorzugt Dichlormethan (DCM), Dioxan, Ethoxyethanol, Butanon, Dimethylformamid (DMF), oder Mischungen davon.

Die Aufarbeitung der erhaltenen Metall-Carben-Komplexe kann nach dem Fachmann bekannten Methoden erfolgen. Zum Beispiel kann der nach Entfernen des Lösungsmittels verbleibende Rückstand zunächst mit Wasser gereinigt und filtriert, getrocknet, mit DCM extrahiert, mittels Säulenchromatographie unter Verwendung von beispielsweise *iso*-Hexanen oder *iso-*Hexanen und Ethyl-Acetat als Elutionsmittel oder einem Elutionsmittel-Gradienten aus diesen gereinigt, und anschließend mit *iso*-Hexanen und Diethylether das so aufgereinigte Produkt gewaschen werden.

Die Vorstufe des zweizähnigen monoanionischen Liganden L kann im Übrigen durch die folgende allgemeine Formel (IV) beschrieben werden 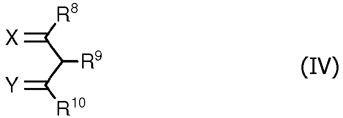 worin X, Y, R⁸, R⁹, R¹⁰ die gleichen Bedeutungen haben wie oben im Zusammenhang mit Formel (II) beschrieben, wobei dem Fachmann klar ist, wie X, Y, R⁸, R⁹, R¹⁰ auszuwählen sind, damit die gewünschte Verbindung der allgemeinen Formel (I) erhalten werden kann.

Entsprechende Verbindungen der Formel (IV) sind nach dem Fachmann bekannten Verfahren zugänglich bzw. können käuflich erworben werden. Die darstellte Formel (IV) entspricht für den Fall, dass X und Y O sind, einem Keto-Tautomer und kann dann folglich auch in der Form eines Enol-Tautomers vorliegen. Besonders bevorzugt wird Acetylaceton eingesetzt.

Die vorliegende Erfindung wird im Folgenden anhand von Ausführungsbeispielen näher beschrieben.

### Beispiele

Die folgenden Beispiele, insbesondere die darin beschriebenen Verfahren, Reagenzien, Reaktionsbedingungen, Verfahrensparameter, Gerätschaften und dergleichen, dienen der Veranschaulichung der vorliegenden Erfindung und sind nicht dahingehend auszulegen, dass sie die Erfindung einengen. Die in den folgenden Beispielen angegebenen Prozentwerte sind in Gewichts-% angegeben und etwaige Angaben zu Verhältnissen sind Gewichtsverhältnisse, sofern nichts anderes angegeben ist.

Die nachfolgend im Anschluss an die Synthese von NHC-Liganden bzw. Ligandvorstufen beschriebenen Komplex-Verbindungen **A** bis **J** wurden unter Schutzgasatmosphäre und bei Lichtausschluss hergestellt. Dimethylformamid wurde getrocknet verwendet.

¹H, ¹³C und ¹⁹⁵Pt NMR-Spektren wurden auf NMR-Spektrometern Bruker NMR Avance 300, Bruker DRX 500 und Bruker Avance 600 NMR gemessen. ¹H und ¹³C NMR-Spektren wurden unter Verwendung der Lösungsmittelresonanz intern referenziert (¹H: 7,26, ¹³C 77,0 für CDCl₃; ¹H 2,50, ¹³C 39,43 für DMSO-*d*₆). ¹⁹⁵Pt NMR-Spektren wurden unter Verwendung von Kaliumtetrachloridoplatinat(II) in D₂O extern referenziert (PtCl₄²⁻: -1617,2). Chemische Verschiebungen δ sind in ppm angegeben, Kopplungskonstanten J in Hz. Elementaranalysen erfolgten unter Verwendung eines Hekatech EA 3000 Euro Vector elemental analyzer. Schmelzpunkte wurden unter Verwendung eines Wagner und Munz PolyTherm A-Systems ermittelt und sind nicht korrigiert. Emitterfilme wurden durch Rakeln einer Lösung des Emitters in 10 Gew.-% PMMA in Dichlormethan auf ein Quarzsubstrat mittels eines 60 µm-Rakels hergestellt. Der Film wurde getrocknet und die Emission wurde unter Stickstoffatmosphäre gemessen. Der getrocknete Film enthielt jeweils 2 Gew.-% Emitter. Die Anregung erfolgte in einem Wellenlängenbereich von 250 - 400 nm (mit einem Monochromator ausgestattete Xe-Lampe), und die Emission wurde mittels eines kalibrierten Systems zur Detektion der Quantenausbeute ermittelt (Hamamatsu, model C9920-02). Bei Quantenausbeuten >10% beträgt die Ungenauigkeit der Quantenausbeute ±2%. Das Abklingen der Phosphoreszenz wurde durch Anregung mit Pulsen einer EPLED (360 nm, 20 kHz) und zeitaufgelöste Photonenzählung (time-resolved photon counting, TCSPC) mit eines Edinburgh Instruments mini-τ-Gerätes gemessen. Absorptionsspektren wurden auf einem Perkin Elmer Lambda 25 UV-VIS-Spektrometer gemessen.

### Liganden bzw. Ligandenvorstufen

### Darstellung von N-Phenylbenzamidin

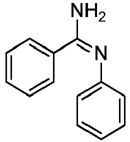

In einem getrockneten 50 ml Rundkolben werden 0,360 g (15 mmol, 1,5 eq) Natriumhydrid in 5 ml DMSO suspendiert und auf 0 °C gekühlt. Es werden 1,031 g (10 mmol) Benzonitril und 1,118 g (12 mmol, 1,2 eq) Anilin zugegeben. Das resultierende Gemisch wird 1 h lang bei 0 °C und anschließend 24 h bei Raumtemperatur gerührt. Nach Abschluss der Reaktion wird das Gemisch in einem Eisbad gekühlt und 20 ml Wasser werden hinzugefügt. Das Präzipitat wird aufgenommen, mit Wasser und iso-Hexanen gewaschen und anschließend im Vakuum getrocknet, was einen hellbraunen, amorphen Feststoff ergibt (4,00 g, 67,9%). Schmelzpunkt: 103 °C; ¹H NMR (300 MHz, CDCl₃): δ = 7,84 (d, *J* = 6,8 Hz, 2H, C*H*ₐᵣₒₘ), 7,55 - 7,40 (m, 3H, C*H*ₐᵣₒₘ), 7,35 (t, *J* = 8,1, 7,6 Hz, 2H, C*H*ₐᵣₒₘ), 7,07 (t, *J=* 7,4 Hz, 1H, C*H*ₐᵣₒₘ), 7,03 - 6,94 (m, 2H, C*H*ₐᵣₒₘ), 4,86 (s, 2H, N*H*); ¹³C NMR (75 MHz, CDCl₃) δ 130,9 (*C*Hₐᵣₒₘ), 129,7 (*C*Hₐᵣₒₘ), 128,8 (*C*Hₐᵣₒₘ), 127,1 (*C*Hₐᵣₒₘ), 123,5 (*C*Hₐᵣₒₘ), 122,0 (*C*Hₐᵣₒₘ); Analyse, berechnet für C₁₃H₁₂N₂: C, 79,56; H, 6,16; N, 14,27; gefunden: C, 79,57; H, 6,39; N, 14,17.

### Darstellung von 1,2-Diphenyl-1H-imidazol

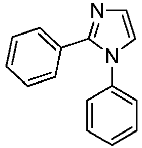

Unter Luftatmosphäre werden 3,925 g (20 mmol) *N-*Phenylbenzamidin in einem mit einem Kühler ausgestatteten 250 ml Rundkolben vorgelegt. 6,280 g (40 mmol, 2 eq.) Chloracetaldehyd (50 Gew.-%-Lösung in Wasser) werden hinzugefügt und das Gemisch wird in 70 ml Trichlormethan gelöst. Die Lösung wird 24 h lang auf 70 °C erwärmt, dann auf Raumtemperatur abgekühlt und mit 30 ml einer gesättigten Lösung von NaHCO₃ in Wasser nachbehandelt. Die Phasen werden getrennt und die wässrige Phase wird mit Dichlormethan (3 × 30 ml) extrahiert. Die kombinierte organische Phase wird mit MgSO₄ getrocknet und konzentriert. Das Produkt wird mittels Flash-Säulenchromatographie unter Verwendung von Ethylacetat als Elutionsmittel isoliert. Nach Trocknung im Vakuum wird das Produkt als ein brauner Feststoff erhalten (3,37 g, 76,5%). Schmelzpunkt: 73 °C; ¹H NMR (300 MHz, CDCl₃) δ 7,46 - 7,35 (m, 5H, C-*H*ₐᵣₒₘ), 7,33 - 7,20 (m, 6H, C-*H*ₐᵣₒₘ), 7,17 (d, *J* = 1,3 Hz, ¹H, C*H*ₐᵣₒₘ); ¹³C NMR (75 MHz, CDCl₃) δ 146,8 (*C*ᵢ), 138,6 (*C*ᵢ), 130,1 (*C*ᵢ), 129,6 (*C*Hₐᵣₒₘ), 128,8 (*C*Hₐᵣₒₘ), 128,8 (*C*Hₐᵣₒₘ ), 128,6 (*C*Hₐᵣₒₘ ), 128,4 (*C*Hₐᵣₒₘ ), 128,3 (*C*Hₐᵣₒₘ ), 126,0 (*C*Hₐᵣₒₘ ), 123,0 (*C*Hₐᵣₒₘ); Analyse, berechnet für C₁₅H₁₂N₂: C, 81,79; H, 5,49; N, 12,72; gefunden: C, 81,75; H, 5,62; N, 12,46.

### Darstellung von 3-Methyl-1,2-diphenyl-1H-imidazoliumiodid

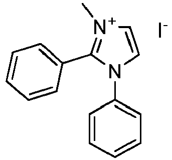

Unter Luftatmosphäre wird ein Druckrohr mit 1,101 g (5 mmol) 1,2-Diphenyl-1H-imidazol und 1,434 g (10 mmol, 2 eq) Methyliodid beladen. Die Reagenzien werden in 3 ml THF gelöst und bei 110 °C 24 h lang gerührt. Das Gemisch wird auf Raumtemperatur abgekühlt, Diethylether wird hinzugefügt und das Präzipitat wird aufgenommen. Der Feststoff wird mit THF (2 × 5 ml) und Diethylether (3 × 5 ml) gewaschen und im Vakuum getrocknet. Das Produkt wird als ein etwas gelbes Pulver erhalten (1,50 g, 82,8%). Schmelzpunkt: 243 °C; ¹H NMR (300 MHz, DMSO-*d*₆) δ 8,18 (d, *J* = 2,1 Hz, ¹H, C-*H*ₐᵣₒₘ), 8,12 (d, *J* = 2,1 Hz, 1H, C*H*ₐᵣₒₘ), 7,66 - 7,46 (m, 8H, C-*H*ₐᵣₒₘ), 7,46 - 7,35 (m, 2H, C-*H*ₐᵣₒₘ), 3,79 (s, 3H, NC*H*₃; ¹³C NMR (75 MHz, DMSO-*d*₆) δ 144,3 (*C*ᵢ), 135,1 (*C*ᵢ), 132,1 (*C*Hₐᵣₒₘ), 130,9 (*C*Hₐᵣₒₘ), 130,1 (*C*Hₐᵣₒₘ), 129,7 (*C*Hₐᵣₒₘ), 129,1 (*C*Hₐᵣₒₘ), 126,2 (*C*Hₐᵣₒₘ), 123,7 (*C*Hₐᵣₒₘ), 123,5 (*C*Hₐᵣₒₘ), 121,4 (*C*ᵢ), 35,89 (N*C*H₃); Analyse, berechnet für C₁₆H₁₅IN₂: C, 53,06; H, 4,17; N, 7,73; gefunden: C, 52,83; H, 3,81; N, 7,75.

### Darstellung von 1,2,3-Triphenyl-1H-imidazoliumtetrafluoroborat

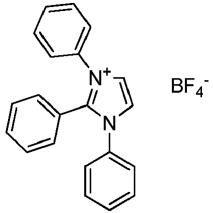

Unter Luftatmosphäre werden 1,652 g (7,5 mmol) 1,2-Diphenyl-1H-imidazol, 3,311 g (9 mmol, 1,2 eq) Diphenyliodoniumtetrafluoroborat und 0,075 g (0,375 mmol, 0,05 eq) Kupfer(II)acetatmonohydrat in einem Schlenkrohr vorgelegt und in 20 ml DMF gelöst. Das Gemisch wird 16 h lang bei 100 °C gerührt, anschließend auf Raumtemperatur abgekühlt und alle flüchtigen Substanzen werden im Vakuum entfernt. Das Produkt wird aus heißem Methanol kristallisiert und in Form von farblosen bis hellbraunen Kristallen erhalten (2,55 g, 88,5%). Schmelzpunkt: 274°C; ¹H NMR (300 MHz, DMSO-*d*₆) δ 8,43 (s, 2H, C-*H*ₐᵣₒₘ), 7,58-7,44 (m, 10H, C-*H*ₐᵣₒₘ), 7,44 - 7,27 (m, 5H, C*H*ₐᵣₒₘ); ¹³C NMR (75 MHz, DMSO-*d*₆) δ 144,5 (*C*ᵢ), 135,0 (*C*ᵢ), 131,8 (*C*Hₐᵣₒₘ), 131,2 (*C*Hₐᵣₒₘ), 130,3 (*C*Hₐᵣₒₘ), 129,7 (*C*Hₐᵣₒₘ), 128,6 (*C*Hₐᵣₒₘ), 126,4 (*C*Hₐᵣₒₘ), 124,0 (*C*Hₐᵣₒₘ), 121,6 (*C*ᵢ); ¹⁹F NMR (282 MHz, DMSO-*d*₆) δ -148,8 (s, *B*F₄⁻), -148,9 (s, *B*F₄⁻); Analyse, berechnet für C₂₁H₁₇BF₄N₂: C, 65,65; H, 4,46; N, 7,29; gefunden: C, 65,75; H, 4,74; N, 7,33.

### Darstellung von 4-Brom-N-phenylbenzamidin

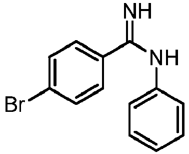

In einem ausgeheizten 100 ml Schlenkkolben werden unter Argonatmosphäre 0,720 g (30 mmol, 1,5 eq) Natriumhydrid vorgelegt und in 5 ml DMSO suspendiert. Unter Kühlung im Eisbad werden 3,640 g (20 mmol) 4-Brombenzonitril und 2,235 g (24 mmol, 1,2 eq) Anilin zugegeben. Die Reaktion wird über Nacht auf Raumtemperatur gerührt und anschließend mit dem dreifachen Volumen Wasser versetzt. Das Gemisch wird filtriert, die Filterkuchen mit Wasser gewaschen, anschließend in DCM gelöst und über Magnesiumsulfat getrocknet. Die organische Phase wird zur Trockne einrotiert, der Feststoff in einem Gemisch aus *iso*-Hexan und Ethylacetat umkristallisiert. Nach Filtration, Waschen mit wenig Diethylether und Trocknen im Vakuum erhält man das Produkt als gelben Feststoff. Ausbeute 1,92 g (35 %); Schmelzpunkt 140 °C; Summenformel: C₁₃H₁₁BrN₂; Molare Masse 275,15 g/mol; ¹H-NMR (300 MHz, CDCl₃) δ (ppm) = 7,73 (d, J = 8,2 Hz, 2H, C-*H*ₐᵣₒₘ), 7,57 (dt, J = 8,6, 2,0 Hz, 2H, C*H*ₐᵣₒₘ), 7,36 (t, J = 7,9 Hz, 2H, C*H*ₐᵣₒₘ), 7,09 (tt, J = 7,4, 1,1 Hz, 1H, C*H*ₐᵣₒₘ), 7,02 - 6,92 (m, 2H, C*H*ₐᵣₒₘ), 4,94 (bs, 2H, N*H*₂); ¹³C-NMR (75 MHz, CDCl₃) δ (ppm) = 131,9 (*C*Hₐᵣₒₘ), 129,74 (*C*Hₐᵣₒₘ), 128,7 (*C*ᵢ), 125,3 (*C*Hₐᵣₒₘ), 123,6 (*C*Hₐᵣₒₘ), 121,8 (*C*Hₐᵣₒₘ) (fehlende quartäre C-Resonanzen im Spektrum nicht sichtbar). Elementaranalyse berechnet: C 56,75 %;
H 4,03 %; N 10,18 %; gefunden:C 56,77 %; H 4,02 %; N 10,18 %.

### Darstellung von 2-(4-Brompheny/)-1-phenyl-1H-imidazol

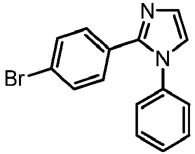

In einem 100 ml Kolben werden 3,027 g (11 mmol) 4-Brom-*N-*phenylbenzamidin und 3,454 g (22 mmol, 2 eq) wässrige Chloracetaldehyd-Lösung (50 %) in 35 ml Chloroform gelöst. Das Gemisch wird 24 h bei 70 °C refluxiert und anschließend mit gesättigter Natriumhydrogencarbonat-Lösung versetzt. Die Phasen werden getrennt und die wässrige Phase wird mit DCM extrahiert (3 × 30 ml). Die vereinte organische Phase wird über Magnesiumsulfat getrocknet und das Lösungsmittel im Vakuum entfernt. Das Rohprodukt wird durch Säulenchromatographie mit dem Elutionsmittelgemisch aus *iso*-Hexan/Ethylacetat (1:2) gereinigt. Nach Trocknen im Vakuum erhält man das Produkt als hellbraunen Feststoff. Ausbeute 2,87 g (87 %); Schmelzpunkt 119 °C; SummenformelC₁₅H₁₁BrN₂; Molare Masse 299,17 g/mol; ¹H NMR (300 MHz, CDCl₃) δ = 7,47 - 7,35 (m, 5H, C-*H*ₐᵣₒₘ), 7,31 - 7,19 (m, 5H, C*H*ₐᵣₒₘ), 7,19 - 7,15 (m, ¹H, C*H*ₐᵣₒₘ).: ¹³C NMR (75 MHz, CDCl₃); δ = 145,6 (*C*ᵢ), 138,3 (*C*ᵢ), 131,5 (*C*Hₐᵣₒₘ), 130,1 (*C*Hₐᵣₒₘ), 129,8 (*C*Hₐᵣₒₘ), 129,0 (*C*Hₐᵣₒₘ), 128,6 (*C*Hₐᵣₒₘ), 126,0 (*C*Hₐᵣₒₘ), 123,3 (*C*Hₐᵣₒₘ), 123,0 (*C*ᵢ) *(die fehlende Cᵢ-Resonanz ist im Spektrum nicht aufgelöst).* Elementaranalyse berechnet: C 60,22 %; H 3,71 %; N 9,36 %.; gefunden: C 60,32 %; H 3,64 %; N 9,32 %.

### Darstellung von 2-(4-Brompheny/)-1,3-diphenyl-1H-imidazoliumtetraf/uoroborat

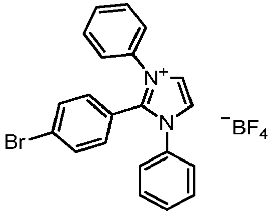

In einem Schlenkrohr werden 1,496 g (5 mmol) 2-(4-Bromphenyl)-1-phenyl-1H-imidazol, 2,759 g (7,5 mmol, 1,5 eq) Diphenyliodoniumtetrafluoroborat und 0,050 g (0,25 mmol, 0,05 eq) Kupfer(II)-acetatmonohydrat vorgelegt und in 20 ml DMF gelöst. Das Gemisch wird bei 100 °C für 18 h gerührt und das Lösungsmittel anschließend im Vakuum entfernt. Der Rückstand wird in wenig Dichlormethan gelöst und über Nacht zum Kristallisieren stehen gelassen. Der Feststoff wird filtriert und mit Ether gewaschen. Nach dem Trocknen im Vakuum erhält man das Produkt als bräunlichen Feststoff.

Ausbeute 1,32 g (57 %); Schmelzpunkt 222 °C; Summenformel C₂₁H₁₆BBrF₄N₂; Molare Masse 463,08 g/mol; ¹H NMR (600 MHz, DMSO-*d*₆) δ = 8,43 (s, ¹H, C-*H*ₐᵣₒₘ), 7,62 - 7,58 (m, ¹H, C*H*ₐᵣₒₘ), 7,58 - 7,52 (m, 3H, C*H*ₐᵣₒₘ), 7,52 - 7,46 (m, 2H, C*H*ₐᵣₒₘ), 7,37 - 7,31 (m, ¹H, C*H*ₐᵣₒₘ); ¹³C NMR (151 MHz, DMSO-*d*₆) δ = 143,5 (*C*ᵢ), 134,8 (*C*ᵢ), 133,2 (*C*Hₐᵣₒₘ), 131,8 (*C*Hₐᵣₒₘ), 130,4 (*C*Hₐᵣₒₘ), 129,8 (*C*Hₐᵣₒₘ), 126,3 (*C*Hₐᵣₒₘ), 125,9 (*C*ᵢ), 124,1 (*C*Hₐᵣₒₘ), 120,8 (*C*ᵢ), Elementaranalyse berechnet: C 54,47 %; H 3,48 %; N 6,05 %; gefunden: C 54,59 %;
H 3,44 %; N 6,19 %.

### Darstellung von 4-Cyano-N-phenylbenzamidin

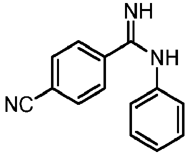

In einem ausgeheizten 100 ml Schlenkkolben werden unter Argonatmosphäre 0,720 g (30 mmol, 1,5 eq) Natriumhydrid vorgelegt und in 10 ml DMSO suspendiert. Unter Kühlung im Eisbad werden 2,563 g (20 mmol) Terephtalsäuredinitril und 2,235 g (24 mmol, 1,2 eq) Anilin zugegeben. Die Reaktion wird über Nacht auf Raumtemperatur gerührt und anschließend mit dem dreifachen Volumen Wasser versetzt. Das Gemisch wird filtriert, die Filterkuchen mit Wasser gewaschen, anschließend in DCM gelöst und über Magnesiumsulfat getrocknet. Die organische Phase wird zur Trockne einrotiert, der Feststoff in Acetronitril umkristallisiert. Nach Filtration, Waschen mit wenig Diethylether und Trocknen im Vakuum erhält man das Produkt als gelben Feststoff.

Ausbeute 1,83 g (41 %); Schmelzpunkt 190 °C; Summenformel C₁₄H₁₁N_{3;} Molare Masse 221,26 g/mol; ¹H NMR (500 MHz, DMSO-*d*₆) δ = 8,12 (d, *J* = 8,1 Hz, 2H, C-*H*ₐᵣₒₘ), 7,91 (d, *J* = 8,2 Hz, 2H, C*H*ₐᵣₒₘ), 7,32 (t, J= 7,6 Hz, 2H, C*H*ₐᵣₒₘ), 7,00 (t, J= 7,4 Hz, 1H, C*H*ₐᵣₒₘ), 6,86 (d, *J* **=** 7,8 Hz, 2H, C*H*ₐᵣₒₘ), 6,48 (s, 2H, N*H*₂); ¹³C NMR (126 MHz, DMSO-*d*₆) δ = 152,7 (*C*ᵢ), 150,1 (*C*ᵢ), 140,3 (*C*ᵢ), 132,2 (*C*Hₐᵣₒₘ), 129,4 (*C*Hₐᵣₒₘ), 128,1 (*C*Hₐᵣₒₘ), 122,4 (*C*Hₐᵣₒₘ), 121,6 (*C*Hₐᵣₒₘ), 118,8 (*C*ᵢ), 112,5 (*C*ᵢ). Elementaranalyse berechnet: C 76,00 %; H 5,01 %; N 18,99 %; gefunden: C 75,62 %; H 4,80 %; N 18,64 %.

### Darstellung von 2-(4-Cyanopheny/)-1-phenyl-1H-imidazol

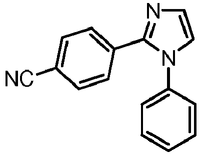

In einem 100 ml Kolben werden 2,213 g (10 mmol) 4-Cyano-*N*-phenylbenzamidin und 3,140 g (20 mmol, 2 eq) wässrige Chloracetaldehyd-Lösung (50 %) in 50 ml Chloroform gelöst. Das Gemisch wird 24 h bei 70 °C refluxiert und anschließend mit gesättigter Natriumhydrogencarbonat-Lösung versetzt. Die Phasen werden getrennt und die wässrige Phase wird mit DCM extrahiert (3 × 30 ml). Die vereinte organische Phase wird über Magnesiumsulfat getrocknet und das Lösungsmittel im Vakuum entfernt. Das Rohprodukt wird durch Säulenchromatographie mit dem Elutionsmittelgemisch aus *iso*-Hexan/Ethylacetat (1:2) gereinigt. Nach Trocknen im Vakuum erhält man das Produkt als hellbraunen Feststoff. Ausbeute 1,50 g (61 %); Schmelzpunkt 113 °C; Summenformel C₁₆H₁₁N₃; Molare Masse 245,28 g/mol; ¹H NMR (300 MHz, CDCl₃) δ = 7,61 - 7,54 (m, 4H), 7,54 - 7,46 (m, 3H), 7,34 (d, J= 1,3 Hz, 1H), 7,31 - 7,23 (m, 3H); ¹³C NMR (75 MHz, CDCl₃) δ = 144,5 (*C*ᵢ), 137,9 (*C*ᵢ), 134,4 (*C*ᵢ), 131,9 (*C*Hₐᵣₒₘ), 129,8 (2 *C*-*H*ₐᵣₒₘ), 128,8 (*C*Hₐᵣₒₘ), 128,7 (*C*Hₐᵣₒₘ), 125,8 (*C*Hₐᵣₒₘ), 124,2 (*C*Hₐᵣₒₘ), 118,5 (*C*ᵢ), 111,6 (*C*ᵢ); Elementaranalyse berechnet: C 78,35 %; H 4,52 %; N 17,13 %; gefunden:C 78,54 %; H 4,63 %; N 16,75 %.

### Darstellung von 2-(4-Cyanoheny/)-1,3-diphenyl-1H-imidazoliumtetrafluoroborat

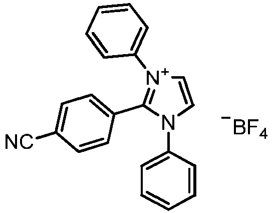

In einem Schlenkrohr werden 1,226 g (5 mmol) 2-(4-Cyanophenyl)-1-phenyl-1*H*-imidazol, 2,649 g (7,2 mmol, 1,44 eq) Diphenyliodoniumtetrafluoroborat und 0,050 g (0,25 mmol, 0,05 eq) Kupfer(II)-acetatmonohydrat vorgelegt und in 20 ml DMF gelöst. Das Gemisch wird bei 100 °C für 18 h gerührt und das Lösungsmittel anschließend im Vakuum entfernt. Der Rückstand wird in Dichlormethan aufgenommen, der Feststoff filtriert und mit DCM gewaschen (3 × 5 ml). Nach dem Trocknen im Vakuum erhält man das Produkt als bräunlichen Feststoff.

Ausbeute 1,73 g (85 %); Schmelzpunkt 174 °C; Summenformel C₂₂H₁₆BF₄N₃; Molare Masse 409,19 g/mol; ¹H NMR in DMSO-*d*₆ (300 MHz) δ = 8,48 (s, 2H, C-*H*ₐᵣₒₘ), 7,87 (d, *J* = 8,4 Hz, 2H, C*H*arom), 7,61 (d, *J* = 8,4 Hz, 2H, C*H*ₐᵣₒₘ), 7,58 - 7,52 (m, 6H, C*H*ₐᵣₒₘ), 7,52 - 7,45 (m, 4H, C*H*ₐᵣₒₘ); ¹³C NMR in DMSO-*d*₆ (75 MHz) δ = 142,7 (*C*ᵢ), 134,6 (*C*ᵢ), 132,4 (*C*Hₐᵣₒₘ), 132,3 (*C*Hₐᵣₒₘ), 130,6 (*C*Hₐᵣₒₘ), 129,9 (*C*Hₐᵣₒₘ), 126,3 (*C*Hₐᵣₒₘ), 126,2 (*C*ᵢ), 124,4 (*C*Hₐᵣₒₘ), 117,5 (*C*ᵢ), 114,3 (*C*ᵢ). Elementaranalyse berechnet: C 64,58 %; H 3,94 %; N 10,27 %; gefunden:C 64,66 %; H 3,94 %; N 10,27 %.

### Carben-Platin(II)-Komplexe

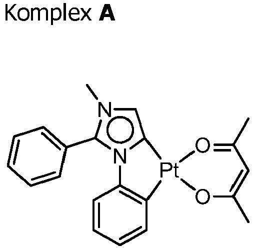

In einem Schlenkrohr werden 0,580 g (1,6 mmol) 3-Methyl-1,2-diphenylimidazoliumiodid und 0,185 g (0,8 mmol, 0,5 eq) Silber(I)-oxid in 40 ml trockenem DMF suspendiert und bei 75 °C 23 h gerührt. Bei Raumtemperatur werden 0,599 g (1,6 mmol, 1 eq) Pt(COD)Cl₂ zugegeben und das Reaktionsgemisch zunächst 3 h bei Raumtemperatur, anschließend 21 h bei 130 °C gerührt. Nach Abkühlen auf Raumtemperatur werden wiederum (6,4 mmol, 4 eq) 0,641 g Acetylaceton und 0,885g (6,4 mmol, 4 eq) Kaliumcarbonat hinzugegeben und zunächst 21 h bei Raumtemperatur, dann 6 h bei 100 °C gerührt. Nach Entfernen der Lösungsmittel im Vakuum wird der Rückstand mit Wasser gewaschen, gefiltert und der Filterkuchen bei 60 °C über Nacht getrocknet. Der Feststoff wird mit DCM extrahiert und anschließend mittels säulenchromatographischer Trennung mit einem Gradienten von *iso*-Hexan/Ethylacetat (2:1) zu reinem Ethylacetat eluiert. Der erhaltene Feststoff wird anschließend mit *iso*-Hexan im Ultraschallbad gewaschen (3 × 5 ml). Nach Trocknen im Vakuum erhält man das Produkt als braunen Feststoff (155 mg, 18 %).

### Schmelzpunkt: 253 °C

¹H NMR (300 MHz, CDCl₃)
δ = 7,84 (t, *J* = 13,8 Hz, 1H, PtCC*H*), 7,74 - 7,57 (m, 3H, C*H*_{para/meta} von C2-Ph), 7,46 (d, *J* = 6,5 Hz, 2H, C*H*ₒᵣₜₕₒ von C2-Ph), 6,91 (t, J= 7,5 Hz, ¹H, C*H*ₚₐᵣₐ von N3-Ph), 6,86 (s, ¹H, NC*H*), 6,63 (t, J= 7,2 Hz, ¹H, C*H*ₘₑₜₐ von N3-Ph), 6,18 (d, J= 8,0 Hz, ¹H, C*H*ₒᵣₜₕₒ von N3-Ph), 5,43 (s, 1H, COC*H*), 3,47 (s, 3H, NC*H*₃), 2,00 (s, 3H, COC*H*₃), 1,95 (s, 3H, COC*H*₃).
¹³C NMR (75 MHz, CDCl₃)
δ = 184,9 (*C*O), 184,8 (*C*O), 148,2 (N*C*CH von N3-Ph), 139,5 (N*C*N), 133,1 (PtC*C*H), 132,1 (Pt*C*N), 131,9 (*C*Hₚₐᵣₐ von C2-Ph), 130,6 (*C*Hₒᵣₜₕₒ von C2-Ph), 130,0 (*C*Hₘₑₜₐ von C2-Ph), 129,6 (PtCCN), 125,5 (*C*Hₚₐᵣₐ von N3-Ph), 124,6 (N*C*CH von C2-Ph), 122,4 (*C*Hₘₑₜₐ von N3-Ph), 120,3 (N*C*H), 113,0 (*C*Hₒᵣₜₕₒ von N3-Ph), 102,0 (COCH), 34,4 (N*C*H₃), 28,3 (CO*C*H₃), 28,1 (CO*C*H₃).
¹⁹⁵Pt NMR (64 MHz, CDCl₃)
δ = -3369,4 (s).

Elementaranalyse berechnet für C₂₁H₂₀N₂O₂Pt . 0,16 CH₂Cl₂: C, 47,97; H, 3,79; N, 5,18; Gefunden: C, 47,25; H, 3,48; N, 5,29.

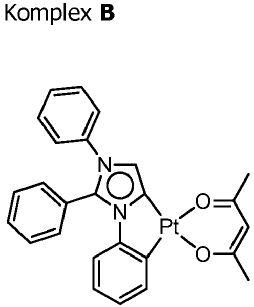

In einem Schlenkrohr werden 0,615 g (1,6 mmol) 1,2,3-Triphenylimidazoliumtetrafluoroborat und 0,185 g (0,8 mmol, 0,5 eq) Silber(I)-oxid in 40 ml trockenem DMF suspendiert und zunächst 20 h bei 80 °C, dann 4 h bei 95 °C gerührt. Bei Raumtemperatur werden 0,599 g (1,6 mmol, 1 eq) Pt(COD)Cl₂ zugegeben und das Reaktionsgemisch zunächst 3 h bei Raumtemperatur, anschließend 21 h bei 125 °C gerührt. Nach Abkühlen auf Raumtemperatur werden wiederum 0,320 g (3,2 mmol, 2 eq) Acetylaceton und 0,442 g (3,2 mmol, 2 eq) Kaliumcarbonat hinzugegeben und zunächst 21 h bei Raumtemperatur, dann 6 h bei 100 °C gerührt. Nach Entfernen der Lösungsmittel im Vakuum wird der Rückstand mit Wasser gewaschen, gefiltert und der Filterkuchen bei 60 °C über Nacht getrocknet. Der Feststoff wird mit DCM extrahiert und anschließend mittels säulenchromatographischer Trennung mit einem Gradienten von *iso*-Hexan/Ethylacetat im Verhältnis 3:1 zu 2:1 eluiert. Der erhaltene Feststoff wird anschließend mit *iso*-Hexan und Diethylether im Ultraschallbad gewaschen (je 3 × 5 ml). Nach Trocknen im Vakuum erhalt man das Produkt als hellbraunen Feststoff (463 mg, 49 %).

### Schmelzpunkt: 300 °C

¹H NMR (600 MHz, CDCl₃)
δ = 7,96 - 7,79 (m, 1H, PtCC*H*, 7,53 (tt, *J* = 7,5, 1,9 Hz, 1H, C*H*ₚₐᵣₐ von C2-Ph), 7,47 (t, *J* = 7,9, 7,3 Hz, 2H, C*H*ₘₑₜₐ von C2-Ph), 7,40 - 7,30 (m, 5H, C*H*ₒᵣₜₕₒ von C2-Ph und C*H*_{meta/para} von N3-Ph), 7,21 - 7,13 (m, 2H, C*H*ₒᵣₜₕₒ von N3-Ph), 7,11 (s, 1H, NC*H*), 6,97 (td, *J* = 7,4, 1,2 Hz, ¹H, C*H*ₚₐᵣₐ von N1-Ph), 6,70 - 6,64 (m, ¹H, C*H*ₘₑₜₐ von N1-Ph), 6,31 (dd, J= 8,1, 1,2 Hz, ¹H, C*H*ₒᵣₜₕₒ von N1-Ph), 5,44 (s, 1H, COC*H*), 2,02 (s, 3H, COC*H*₃), 1,94 (s, 3H, COC*H*₃).
¹³C NMR (75 MHz, CDCl₃)
δ = 185,1 (*C*O), 184,9 (*C*O), 148,0 (N*C*CH von N1-Ph), 139,4 (N*C*N), 136,3 (N*C*CH von N3-Ph), 133,2 (PtC*C*H), 132,4 (Pt*C*N), 131,6 (*C*Hₚₐᵣₐ von C2-Ph), 131,0 (*C*Hₒᵣₜₕₒ von C2-Ph), 130,1 (PtC*C*N), 129,6 (*C*Hₘₑₜₐ von C2-Ph/*C*Hₚₐᵣₐ von N3-Ph), 129,5 (*C*Hₘₑₜₐ von C2-Ph/*C*Hₚₐᵣₐ von N3-Ph), 129,3 (*C*Hₚₐᵣₐ von N3-Ph), 126,0 (*C*Hₒᵣₜₕₒ von N3-Ph), 125,9 (*C*Hₚₐᵣₐ von N1-Ph), 124,6 (N*C*CH von C2-Ph), 122,6 (*C*Hₘₑₜₐ von N1-Ph), 120,9 (N*C*H), 113,7 (*C*Hₒᵣₜₕₒ von N1-Ph), 102,1 (COCH), 28,3 (CO*C*H₃), 28,1 (CO*C*H₃).
¹⁹⁵Pt NMR (64 MHz, CDCl₃)
δ = -3371,6 (s).

Elementaranalyse berechnet für C₂₆H₂₂N₂O₂Pt: C, 52,97; H, 3,76; N, 4,75; Gefunden: C, 52,65; H, 3,57; N, 4,75.

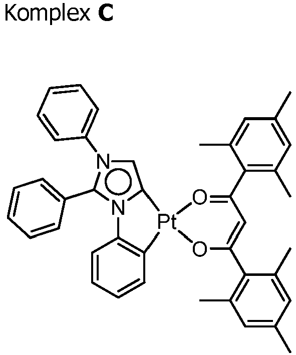

In einem Schlenkrohr werden 0,615 g (1,6 mmol) 1,2,3-Triphenylimidazoliumtetrafluoroborat und 0,185 g (0,8 mmol, 0,5 eq) Silber(I)-oxid in 40 ml trockenem DMF suspendiert und 24 bei 75 °C gerührt. Bei Raumtemperatur werden 0,599 g (1,6 mmol, 1 eq) Pt(COD)Cl₂ zugegeben und das Reaktionsgemisch zunächst 3 h bei Raumtemperatur, anschließend 21 h bei 125 °C gerührt. Nach Abkühlen auf Raumtemperatur werden wiederum 0,987 g (3,2 mmol, 2 eq) Bis-1,3-(2,4,6-trimethylphenyl)propan-1,3-dion und 0,359 g (3,2 mmol, 2 eq) Kalium-*tert*-butanolat hinzugegeben und zunächst 21 h bei Raumtemperatur, dann 6 h bei 100 °C gerührt. Nach Entfernen der Lösungsmittel im Vakuum wird der Rückstand mit Wasser gewaschen, gefiltert und der Filterkuchen bei 60 °C über Nacht getrocknet. Der Feststoff wird mit DCM extrahiert und anschließend mittels säulenchromatographischer Trennung mit einem Gradienten von *iso*-Hexan/DCM im Verhältnis 1:2 eluiert. Der erhaltene Feststoff wird anschließend mit *iso*-Hexan im Ultraschallbad gewaschen (je 3 × 5 ml). Nach Trocknen im Vakuum erhalt man das Produkt als gelben Feststoff (116 mg, 9 %).

### Schmelzpunkt: 312 °C

¹H NMR (300 MHz, CDCl₃)
δ = 7,95 - 7,67 (m, ¹H, C*H*ₐᵣₒₘ), 7,60 - 7,41 (m, 3H C*H*ₐᵣₒₘ), 7,39 - 7,24 (m, 5H, C*H*ₐᵣₒₘ), 7,13 (dd, J= 7,6, 2,1 Hz, 2H, C-*H*ₐᵣₒₘ), 7,08 (s, 1H, C-*H*ₐᵣₒₘ), 6,93 - 6,83 (m, 3H, C-*H*ₐᵣₒₘ), 6,81 (s, 2H, C*H*ₐᵣₒₘ), 6,73 - 6,56 (m, 1H, C-*H*ₐᵣₒₘ), 6,30 (dd, J= 8,1, 1,2 Hz, 1H, C-*H*ₐᵣₒₘ), 5,60 (s, ¹H, COC*H*), 2,39 (s, 6H, CC*H*₃), 2,36 (s, 6H, CC*H*₃), 2,29 (s, 3H, CC*H*₃), 2,26 (s, 3H, CC*H*₃). ¹³C NMR (75 MHz, CDCl₃)
δ = 184,6 (*C*O), 184,1 (*C*O), 147,9 (*C*ᵢ), 140,2 (*C*ᵢ), 140,1 (*C*ᵢ), 139,3 (*C*ᵢ), 137,3 (*C*ᵢ), 137,3 (*C*ᵢ), 136,1 (*C*ᵢ), 134,3 (*C*ᵢ), 134,1 (*C*ᵢ), 133,7 (*C*Hₐᵣₒₘ), 132,0 (*C*ᵢ), 131,6 (*C*Hₐᵣₒₘ), 130,9 (*C*H_{arom),} 129,8 (*C*ᵢ), 129,5 (*C*Hₐᵣₒₘ), 129,2 (*C*Hₐᵣₒₘ), 128,2 (*C*Hₐᵣₒₘ), 128,1 (*C*Hₐᵣₒₘ), 125,9 (*C*Hₐᵣₒₘ), 125,2 (*C*Hₐᵣₒₘ), 124,6 (*C*ᵢ), 122,7 (*C*Hₐᵣₒₘ), 121,3 (*C*Hₐᵣₒₘ), 115,2 (*C*Hₐᵣₒₘ), 113,6 (*C*Hₐᵣₒₘ); 107,0 (*C*Hₐᵣₒₘ), 21,2 (C*C*H₃), 21,2 (C*C*H₃), 20,0 (C*C*H₃), 19,9 (C*C*H₃).
¹⁹⁵Pt NMR (64 MHz, CDCl₃)
δ = -3306,7 (s).

Elementaranalyse berechnet für C₄₂H₃₈N₂O₂Pt: C, 63,23; H, 4,80; N, 3,51; Gefunden: C, 63,50; H, 4,90; N, 3,47.

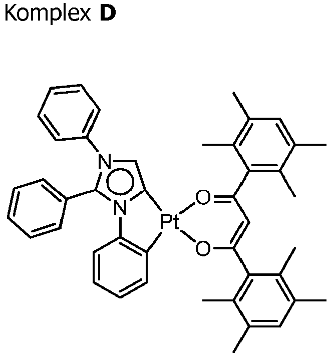

In einem Schlenkrohr werden 0,307 g (0,8 mmol) 1,2,3-Triphenylimidazoliumtetrafluoroborat und 0,093 g (0,4 mmol, 0,5 eq) Silber(I)-oxid in 20 ml trockenem DMF suspendiert und 24 bei 75 °C gerührt. Bei Raumtemperatur werden 0,299 g (0,8 mmol, 1 eq) Pt(COD)Cl₂ zugegeben und das Reaktionsgemisch zunächst 3 h bei Raumtemperatur, anschließend 21 h bei 125 °C gerührt. Nach Abkühlen auf Raumtemperatur werden wiederum 0,538 g (1,6 mmol, 2 eq) Bis-1,3-(2,3,5,6-tetramethylphenyl)propan-1,3-dion und 0,180 g (1,6 mmol, 2 eq) Kalium-*tert*-butanolat hinzugegeben und zunächst 21 h bei Raumtemperatur, dann 6 h bei 100 °C gerührt. Nach Entfernen der Lösungsmittel im Vakuum wird der Rückstand mit Wasser gewaschen, gefiltert und der Filterkuchen bei 60 °C über Nacht getrocknet. Der Feststoff wird mit DCM extrahiert und anschließend mittels säulenchromatographischer Trennung mit einem Gradienten von *iso*-Hexan/DCM im Verhältnis 1:2 eluiert. Der erhaltene Feststoff wird anschließend mit *iso*-Hexan im Ultraschallbad gewaschen (je 3 × 5 ml). Nach Trocknen im Vakuum erhalt man das Produkt als gelben Feststoff (55 mg, 8 %).

### Schmelzpunkt: > 300 °C (Zersetzung)

¹H NMR (600 MHz, CDCl₃)
δ = 7,81 (dd, J= 7,6, 1,5 Hz, 1H), 7,58 - 7,51 (m, 1H), 7,51 - 7,44 (m, 2H), 7,37 - 7,33 (m, 2H), 7,33 - 7,27 (m, 3H), 7,17 - 7,11 (m, 2H), 7,11 (s, 1H), 6,93 (s, 1H), 6,90 - 6,84 (m, 2H), 6,65 (ddd, J= 8,2, 7,3, 1,5 Hz, 1H), 6,29 (dd, *J =* 8,1, 1,2 Hz, 1H), 5,57 (s, 1H), 2,29 (s, 6H), 2,26 (s, 6H), 2,23 (s, 6H), 2,19 (s, 6H).
¹³C NMR (151 MHz, CDCl₃)
δ = 185,7 (*C*O), 185,3 (*C*O), 147,9 (*C*ᵢ), 143,3 (*C*ᵢ), 143,2 (*C*ᵢ), 139,2 (*C*ᵢ), 136,1 (*C*ᵢ), 133,8 (*C*Hₐᵣₒₘ), 133,6 (*C*ᵢ), 131,9 (*C*ᵢ), 131,5 (*C*Hₐᵣₒₘ), 130,9 (*C*Hₐᵣₒₘ), 130,9 (*C*Hₐᵣₒₘ), 130,8 (*C*Hₐᵣ-om), 129,9 (*C*ᵢ), 129,7 (*C*ᵢ), 129,5 (*C*Hₐᵣₒₘ), 129,5 (*C*Hₐᵣₒₘ), 129,2 (*C*Hₐᵣₒₘ), 125,9 (*C*Hₐᵣₒₘ), 125,8 (*C*Hₐᵣₒₘ), 124,6 (*C*ᵢ), 122,7 (*C*Hₐᵣₒₘ), 121,4 (*C*Hₐᵣₒₘ), 113,5 (*C*H.ᵣₒₘ), 107,5 (*C*Hₐᵣₒₘ), 19,9 (C*C*H₃), 19,8 (C*C*H₃), 16,6 (C*C*H₃), 16,5 (C*C*H₃).

### Zwei fehlende Cᵢ-Resonanzen sind im Spektrum nicht aufgelöst

¹⁹⁵Pt NMR (64 MHz, CDCl₃)
δ = -3318,1 (s).

Elementaranalyse berechnet für C₄₄H₄₂N₂O₂Pt: C, 63,99; H, 5,13; N, 3,39; Gefunden: C, 64,11; H, 5,36; N, 3,32.

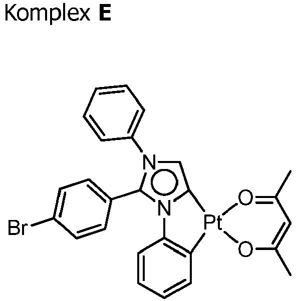

In einem Schlenkrohr werden 0,370 g (0,8 mmol) 2-(4-Bromphenyl)-1,3-diphenyl-1*H-*imidazoliumtetrafluoroborat und 0,093 g (0,4 mmol, 0,5 eq) Silber(I)-oxid in 20 ml trockenem DMF suspendiert und 24 bei 75 °C gerührt. Bei Raumtemperatur werden 0,299 g (0,8 mmol, 1 eq) Pt(COD)Cl₂ zugegeben und das Reaktionsgemisch zunächst 3 h bei Raumtemperatur, anschließend 21 h bei 125 °C gerührt. Nach Abkühlen auf Raumtemperatur werden wiederum 0,160 g (1,6 mmol, 2 eq) Acetylaceton und 0,221 g (1,6 mmol, 2 eq) Kaliumcarbonat hinzugegeben und zunächst 21 h bei Raumtemperatur, dann 6 h bei 100 °C gerührt. Nach Entfernen der Lösungsmittel im Vakuum wird der Rückstand mit Wasser gewaschen, gefiltert und der Filterkuchen bei 60 °C über Nacht getrocknet. Der Feststoff wird mit DCM extrahiert und anschließend mittels säulenchromatographischer Trennung mit dem Elutionsmittel DCM gereinigt. Der erhaltene Feststoff wird anschließend mit *iso*-Hexan im Ultraschallbad gewaschen (je 3 × 5 ml). Nach Trocknen im Vakuum erhalt man das Produkt als braunen Feststoff (135 mg, 25 %).

### Schmelzpunkt: > 250 °C (dec.)

¹H NMR (600 MHz, CDCl₃)
δ = 7,96 - 7,80 (m, ¹H, C*H*ₐᵣₒₘ), 7,61 (d, J= 8,4 Hz, 2H, C*H*ₐᵣₒₘ), 7,37 (m, 3H, C*H*ₐᵣₒₘ), 7,25 (d, *J* = 9,8 Hz, 2H, C*H*ₐᵣₒₘ), 7,16 (d, *J* = 6,9 Hz, 2H, C*H*ₐᵣₒₘ), 7,11 (s, 1H, C*H*ₐᵣₒₘ), 6,98 (t, *J* = 7,4 Hz, ¹H, C*H*ₐᵣₒₘ), 6,72 (t, *J* = 7,7 Hz, ¹H, C*H*ₐᵣₒₘ), 6,34 (d, J= 8,0 Hz, 1H, C*H*ₐᵣₒₘ), 5,44 (s, 1H, COC*H*), 2,02 (s, 3H, CC*H*₃), 1,93 (s, 3H, CC*H*₃).
¹³C NMR (151 MHz, CDCl₃)
δ = 185,0 (*C*O), 184,9 (*C*O), 147,7 (*C*ᵢ), 138,1 (*C*ᵢ), 136,0 (*C*ᵢ), 133,3 (*C*Hₐᵣₒₘ), 133,0 (*C*ᵢ), 132,9 (*C*Hₐᵣₒₘ ), 132,5 (*C*Hₐᵣₒₘ ), 130,3 (*C*ᵢ), 129,8 (*C*Hₐᵣₒₘ ), 129,5 (*C*Hₐᵣₒₘ ), 126,4 (*C*ᵢ), 126,1 (*C*Hₐᵣₒₘ), 126,0 (*C*Hₐᵣₒₘ), 123,4 (*C*ᵢ), 122,6 (*C*Hₐᵣₒₘ), 121,3 (*C*Hₐᵣₒₘ), 113,5 *(C*Hₐᵣₒₘ), 102,0 (*C*Hₐᵣₒₘ), 28,2 (C*C*H₃), 28,0 (C*C*H₃).
¹⁹⁵Pt NMR (64 MHz, CDCl₃)
δ = -3374,5 (s).

Elementaranalyse berechnet für C₂₆H₂₁BrN₂O₂Pt: C, 46,72; H, 3,17; N, 4,19; Gefunden: C, 46,84; H, 3,26; N, 4,39.

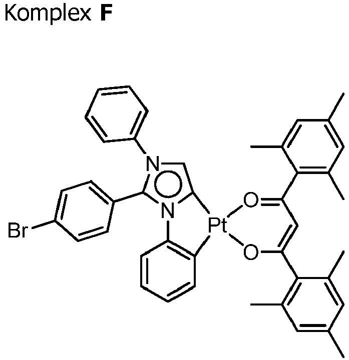

In einem Schlenkrohr werden 0,556 g (1,2 mmol) 2-(4-Bromphenyl)-1,3-diphenyl-1*H-*imidazoliumtetrafluoroborat und 0,139 g (0,6 mmol, 0,5 eq) Silber(I)-oxid in 30 ml trockenem DMF suspendiert und 24 bei 75 °C gerührt. Bei Raumtemperatur werden 0,449 g (1,2 mmol, 1 eq) Pt(COD)Cl₂ zugegeben und das Reaktionsgemisch zunächst 3 h bei Raumtemperatur, anschließend 21 h bei 125 °C gerührt. Nach Abkühlen auf Raumtemperatur werden wiederum 0,740 g (2,4 mmol, 2 eq) Bis-1,3-(2,4,6-trimethylphenyl)propan-1,3-dion und 0,269 g (2,4 mmol, 2 eq) Kalium-*tert*-butanolat hinzugegeben und zunächst 21 h bei Raumtemperatur, dann 6 h bei 100 °C gerührt. Nach Entfernen der Lösungsmittel im Vakuum wird der Rückstand mit Wasser gewaschen, gefiltert und der Filterkuchen bei 60 °C über Nacht getrocknet. Der Feststoff wird mit DCM extrahiert und anschließend mittels säulenchromatographischer Trennung mit einem Gradienten aus *iso*-Hexan/DCM (2:5) eluiert. Der erhaltene Feststoff wird anschließend mit *iso*-Hexan im Ultraschallbad gewaschen (je 3 × 5 ml). Nach Trocknen im Vakuum erhalt man das Produkt als gelben Feststoff (96 mg, 14 %).

### Schmelzpunkt: > 300 °C (Zersetzung)

¹H NMR (300 MHz, CDCl₃)
δ = 7,96 - 7,68 (m, ¹H, C*H*ₐᵣₒₘ), 7,66 - 7,57 (m, 2H, C*H*ₐᵣₒₘ), 7,42 - 7,27 (m, 3H, C*H*ₐᵣₒₘ), 7,27 - 7,17 (m, 2H, C*H*ₐᵣₒₘ), 7,14 - 7,09 (m, 2H, C*H*ₐᵣₒₘ), 7,08 (s, 1H, C*H*ₐᵣₒₘ), 6,91 (td, *J* = 7,4, 1,2 Hz, 1H, C*H*ₐᵣₒₘ), 6,85 (s, 2H, C*H*ₐᵣₒₘ), 6,81 (s, 2H, C*H*ₐᵣₒₘ), 6,70 (m, 1H, C*H*ₐᵣₒₘ), 6,33 (dd, J= 8,1, 1,1 Hz, 1H, C*H*ₐᵣₒₘ), 5,61 (s, 1H, COC*H*), 2,39 (s, 6H, CC*H*₃), 2,35 (s, 6H, CC*H*₃), 2,30 (s, 3H, CC*H*₃), 2,26 (s, 3H, CC*H*₃).
¹³C NMR (75 MHz, CDCl₃)
δ = 184,6 (*C*O), 184,2 (*C*O), 147,7 (*C*ᵢ), 140,2 (*C*ᵢ), 140,1 (*C*ᵢ), 138,0 (*C*ᵢ), 137,3 (*C*ᵢ), 137,3 (*C*ᵢ), 135,9 (*C*ᵢ), 134,3 (*C*ᵢ), 134,0 (*C*ᵢ), 133,9 (*C*Hₐᵣₒₘ), 133,0 (*C*Hₐᵣₒₘ), 132,6 (*C*ᵢ), 132,4 (*C*Hₐᵣ-ₒₘ), 129,9 (*C*ᵢ), 129,7 (*C*Hₐᵣₒₘ), 129,5 (*C*Hₐᵣₒₘ), 128,2 (*C*Hₐᵣₒₘ), 128,1 (*C*Hₐᵣₒₘ), 126,4 (*C*ᵢ), 126,0 (*C*Hₐᵣₒₘ), 125,9 (*C*Hₐᵣₒₘ), 123,4 (*C*ᵢ), 122,8 (*C*Hₐᵣₒₘ), 121,6 (*C*Hₐᵣₒₘ), 113,5 (*C*Hₐᵣₒₘ); 107,0 (*C*Hₐᵣₒₘ), 21,2 (C*C*H₃), 21,2 (C*C*H₃), 20,0 (C*C*H₃), 19,9 (C*C*H₃).
¹⁹⁵Pt NMR (64 MHz, CDCl₃)
δ = -3309,1 (s).

Elementaranalyse berechnet für C₄₂H₃₇BrN₂O₂Pt: C, 57,54; H, 4,25; N, 3,20; Gefunden: C, 57,63; H, 4,41; N, 3,18.

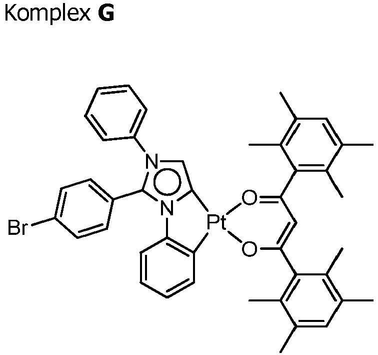

In einem Schlenkrohr werden 0,556 g (1,2 mmol) 2-(4-Bromphenyl)-1,3-diphenyl-1*H-*imidazoliumtetrafluoroborat und 0,139 g (0,6 mmol, 0,5 eq) Silber(I)-oxid in 30 ml trockenem DMF suspendiert und 24 bei 75 °C gerührt. Bei Raumtemperatur werden 0,449 g (1,2 mmol, 1 eq) Pt(COD)Cl₂ zugegeben und das Reaktionsgemisch zunächst 3 h bei Raumtemperatur, anschließend 21 h bei 125 °C gerührt. Nach Abkühlen auf Raumtemperatur werden wiederum 0,808 g (2,4 mmol, 2 eq) Bis-1,3-(2,3,5,6-tetramethylphenyl)propan-1,3-dion und 0,269 g (2,4 mmol, 2 eq) Kalium-*tert*-butanolat hinzugegeben und zunächst 21 h bei Raumtemperatur, dann 6 h bei 100 °C gerührt. Nach Entfernen der Lösungsmittel im Vakuum wird der Rückstand mit Wasser gewaschen, gefiltert und der Filterkuchen bei 60 °C über Nacht getrocknet. Der Feststoff wird mit DCM extrahiert und anschließend mittels säulenchromatographischer Trennung mit einem Gradienten aus *iso*-Hexan/DCM (2:5) eluiert. Der erhaltene Feststoff wird anschließend mit *iso*-Hexan im Ultraschallbad gewaschen (je 3 × 5 ml). Nach Trocknen im Vakuum erhalt man das Produkt als gelben Feststoff (56 mg, 8 %).

### Schmelzpunkt: > 300 °C (Zersetzung)

¹H NMR (300 MHz, CDCl₃)
δ = 7,95 - 7,71 (m, ¹H, C*H*ₐᵣₒₘ), 7,62 (d, J= 8,4 Hz, 2H, C*H*ₐᵣₒₘ), 7,40 - 7,28 (m, 3H, C*H*ₐᵣₒₘ), 7,22 (d, *J* = 8,4 Hz, 2H, C*H*ₐᵣₒₘ), 7,16 - 7,07 (m, 3H, C*H*ₐᵣₒₘ), 6,98 - 6,86 (m, 3H, C*H*ₐᵣₒₘ), 6,75 - 6,64 (m, ¹H, C*H*ₐᵣₒₘ), 6,33 (dd, J= 8,1, 1,2 Hz, ¹H, C*H*ₐᵣₒₘ), 5,57 (s, ¹H, COC*H*), 2,29 (s, 6H, CC*H*₃), 2,25 (s, 6H, CC*H*₃), 2,23 (s, 6H, CC*H*₃), 2,19 (s, 6H, CC*H*₃).
¹³C NMR (75 MHz, CDCl₃) δ 185,8 (*C*O), 185,3 (*C*O), 147,73, 143,28, 143,23, 135,92, 134,00, 133,68, 133,01, 132,66, 132,46, 130,97, 130,89, 129,93, 129,77, 129,71, 129,48, 126,44, 126,03, 125,92, 123,47, 122,79, 121,79, 113,47, 107,56, 19,91, 19,84, 16,66, 16,58.
¹⁹⁵Pt NMR (64 MHz, CDCl₃)
δ = -3320,8 (s).

Elementaranalyse berechnet für C₄₄H₄₁BrN₂O₂Pt: C, 58,41; H, 4,57; N, 3,10; Gefunden: C, 58,25; H, 4,97; N, 3,06.

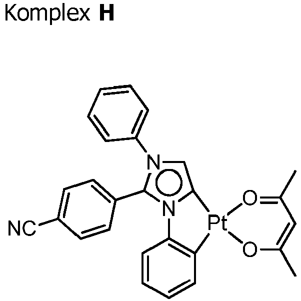

In einem Schlenkrohr werden 0,327 g (0,8 mmol) 2-(4-Cyanophenyl)-1,3-diphenyl-1*H-*imidazoliumtetrafluoroborat und 0,093 g (0,64 mmol, 0,8 eq) Silber(I)-oxid in 20 ml trockenem DMF suspendiert und 24 bei 75 °C gerührt. Bei Raumtemperatur werden 0,299 g (0,8 mmol, 1 eq) Pt(COD)Cl₂ zugegeben und das Reaktionsgemisch zunächst 3 h bei Raumtemperatur, anschließend 21 h bei 125 °C gerührt. Nach Abkühlen auf Raumtemperatur werden wiederum 0,320 g (3,2 mmol, 4 eq) Acetylaceton und 0,442 g (3,2 mmol, 4 eq) Kaliumcarbonat hinzugegeben und zunächst 21 h bei Raumtemperatur, dann 6 h bei 100 °C gerührt. Nach Entfernen der Lösungsmittel im Vakuum wird der Rückstand mit Wasser gewaschen, gefiltert und der Filterkuchen bei 60 °C über Nacht getrocknet. Der Feststoff wird mit DCM extrahiert und anschließend mittels säulenchromatographischer Trennung mit dem Elutionsmittelgemisch DCM/MeOH (1 % MeOH) gereinigt. Der erhaltene Feststoff wird anschließend mit *iso*-Hexan im Ultraschallbad gewaschen (je 3 × 5 ml). Nach Trocknen im Vakuum erhalt man das Produkt als braunen Feststoff (130 mg, 26 %).

### Schmelzpunkt: > 250 °C (dec.)

¹H NMR (600 MHz, CDCl₃)
δ = 7,89 (dd, *J=* 7,6, 1,4 Hz, ¹H, C*H*ₐᵣₒₘ), 7,76 (d, *J* = 8,1 Hz, 2H, C*H*ₐᵣₒₘ), 7,53 (d, J= 8,2 Hz, 2H, C*H*ₐᵣₒₘ), 7,44 - 7,34 (m, 3H), 7,18 - 7,12 (m, 3H, C*H*ₐᵣₒₘ), 7,00 (td, *J* = 7,4, 1,2 Hz, ¹H, C*H*ₐᵣₒₘ), 6,75 - 6,67 (m, 1H, C*H*ₐᵣₒₘ), 6,27 (dd, *J* = 8,1, 1,1 Hz, ¹H, C*H*ₐᵣₒₘ), 5,45 (s, ¹H, COC*H*), 2,03 (s, 3H, CC*H*₃), 1,94 (s, 3H, CC*H*₃).
¹³C NMR (151 MHz, CDCl₃)
δ = 185,1 (*C*O), 184,9 (*C*O), 147,4 (*C*ᵢ), 136,9 (*C*ᵢ), 135,6 (*C*ᵢ), 134,0 (*C*ᵢ), 133,5 (*C*Hₐᵣₒₘ), 133,1 (*C*Hₐᵣₒₘ), 131,9 (*C*Hₐᵣₒₘ), 130,5 (*C*ᵢ), 130,0 (*C*Hₐᵣₒₘ), 129,9 (*C*Hₐᵣₒₘ), 129,0 (*C*ᵢ), 126,3 (*C*Hₐᵣₒₘ), 126,0 (*C*Hₐᵣₒₘ), 122,6 (*C*Hₐᵣₒₘ), 121,8 (*C*Hₐᵣₒₘ), 117,5 (*C*ᵢ), 115,5 (*C*ᵢ), 113,4 (*C*Hₐᵣₒₘ), 102,1 (*C*Hₐᵣₒₘ), 28,2 (C*C*H₃), 28,0 (C*C*H₃).
¹⁹⁵Pt NMR (64 MHz, CDCl₃)
δ = -3374,6 (s).

Elementaranalyse berechnet für C₂₇H₂₁N₃O₂Pt: C, 52,77; H, 3,44; N, 6,84; Gefunden: C, 52,45; H, 3,27; N, 6,86.

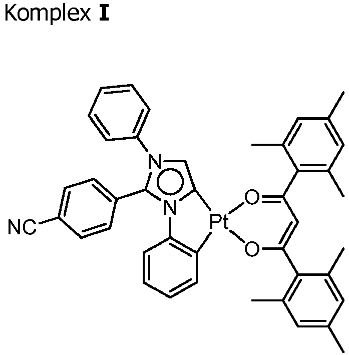

In einem Schlenkrohr werden 0,491 g (1,2 mmol) 2-(4-Cyanophenyl)-1,3-diphenyl-1*H-*imidazoliumtetrafluoroborat und 0,139 g (0,6 mmol, 0,5 eq) Silber(I)-oxid in 30 ml trockenem DMF suspendiert und 24 bei 75 °C gerührt. Bei Raumtemperatur werden 0,449 g (1,2 mmol, 1 eq) Pt(COD)Cl₂ zugegeben und das Reaktionsgemisch zunächst 3 h bei Raumtemperatur, anschließend 21 h bei 125 °C gerührt. Nach Abkühlen auf Raumtemperatur werden wiederum 0,740 g (2,4 mmol, 2 eq) Bis-1,3-(2,4,6-trimethylphenyl)propan-1,3-dion und 0,269 g (2,4 mmol, 2 eq) Kalium-*tert*-butanolat hinzugegeben und zunächst 21 h bei Raumtemperatur, dann 6 h bei 100 °C gerührt. Nach Entfernen der Lösungsmittel im Vakuum wird der Rückstand mit Wasser gewaschen, gefiltert und der Filterkuchen bei 60 °C über Nacht getrocknet. Der Feststoff wird mit DCM extrahiert und anschließend mittels säulenchromatographischer Trennung mit einem Gradienten aus *iso*-Hexan/DCM (2:5) eluiert. Der erhaltene Feststoff wird anschließend mit *iso*-Hexan im Ultraschallbad gewaschen (je 3 × 5 ml). Nach Trocknen im Vakuum erhalt man das Produkt als gelben Feststoff (134 mg, 20 %). Schmelzpunkt: > 300 °C (Zersetzung)
¹H NMR (300 MHz, CDCl₃)
δ = 7,99 - 7,68 (m, 3H, C*H*ₐᵣₒₘ), 7,50 (d, J= 8,4 Hz, 2H, C-*H*ₐᵣₒₘ), 7,42 - 7,29 (m, 3H, C*H*ₐᵣₒₘ), 7,19 - 7,04 (m, 3H, C*H*ₐᵣₒₘ), 6,92 (td, J= 7,4, 1,2 Hz, ¹H, C*H*ₐᵣₒₘ), 6,83 (d, J= 14,4 Hz, 4H, C*H*ₐᵣₒₘ), 6,69 (td, *J* = 7,8, 7,4, 1,5 Hz, 1H, C-*H*ₐᵣₒₘ), 6,26 (dd, *J* = 8,1, 1,1 Hz, 1H, C*H*ₐᵣₒₘ), 5,62 (s, 1H, COC*H*), 2,38 (s, 6H, CC*H*₃), 2,34 (s, 6H, CC*H*₃), 2,29 (s, 3H, CC*H*₃), 2,25 (s, 3H, CC*H*₃).
¹³C NMR (75 MHz, CDCl₃)
δ = 184,7 (*C*O), 184,3 (*C*O), 147,4 (*C*ᵢ), 140,1 (*C*ᵢ), 140,0 (*C*ᵢ), 137,4 (2 *C*ᵢ), 136,8 (*C*ᵢ), 135,5 (*C*ᵢ), 134,2 (*C*ᵢ), 134,0 (*C*Hₐᵣₒₘ), 133,6 (*C*ᵢ), 133,1 (*C*Hₐᵣₒₘ), 131,9 (*C*Hₐᵣₒₘ), 130,2 (*C*ᵢ), 129,9 (*C*Hₐᵣₒₘ ), 129,8 (*C*Hₐᵣₒₘ ), 129,0 (*C*ᵢ), 128,2 (*C*Hₐᵣₒₘ ), 128,1 (*C*Hₐᵣₒₘ ), 126,3 (*C*Hₐᵣₒₘ ), 125,9 (*C*Hₐᵣₒₘ), 122,8 (*C*Hₐᵣₒₘ), 122,2 (*C*Hₐᵣₒₘ), 117,4 (*C*ᵢ), 115,5 (*C*ᵢ), 113,3 (*C*Hₐᵣₒₘ), 107,1 (*C*Hₐᵣ₋ₒₘ), 100,1 (*C*ᵢ), 21,2 (2 C*C*H₃), 20,0 (C*C*H₃), 19,9 (C*C*H₃).
¹⁹⁵Pt NMR (64 MHz, CDCl₃)
δ = -3314,12 (d, *J* = 55,4 Hz).

Elementaranalyse berechnet für C₄₃H₃₇N₃O₂Pt: C, 62,76; H, 4,53; N, 5,11; Gefunden: C, 63,00; H, 4,59; N, 5,03.

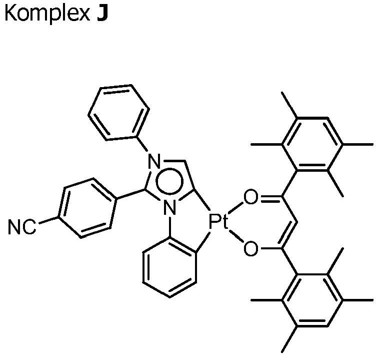

In einem Schlenkrohr werden 0,491 g (1,2 mmol) 2-(4-Cyanophenyl)-1,3-diphenyl-1*H-*imidazoliumtetrafluoroborat und 0,139 g (0,6 mmol, 0,5 eq) Silber(I)-oxid in 30 ml trockenem DMF suspendiert und 24 bei 75 °C gerührt. Bei Raumtemperatur werden 0,449 g (1,2 mmol, 1 eq) Pt(COD)Cl₂ zugegeben und das Reaktionsgemisch zunächst 3 h bei Raumtemperatur, anschließend 21 h bei 125 °C gerührt. Nach Abkühlen auf Raumtemperatur werden wiederum 0,808 g (2,4 mmol, 2 eq) Bis-1,3-(2,3,5,6-tetramethylphenyl)propan-1,3-dion und 0,269 g (2,4 mmol, 2 eq) Kalium-*tert*-butanolat hinzugegeben und zunächst 21 h bei Raumtemperatur, dann 6 h bei 100 °C gerührt. Nach Entfernen der Lösungsmittel im Vakuum wird der Rückstand mit Wasser gewaschen, gefiltert und der Filterkuchen bei 60 °C über Nacht getrocknet. Der Feststoff wird mit DCM extrahiert und anschließend mittels säulenchromatographischer Trennung mit einem Gradienten aus *iso*-Hexan/DCM (2:5) eluiert. Der erhaltene Feststoff wird anschließend mit *iso*-Hexan im Ultraschallbad gewaschen (je 3 x 5 ml). Nach Trocknen im Vakuum erhalt man das Produkt als gelben Feststoff (32 mg, 5 %). Schmelzpunkt: > 300 °C (Zersetzung)
¹H NMR (300 MHz, CDCl₃)
δ = 7,98 - 7,66 (m, 3H, *CH*ₐᵣₒₘ), 7,50 (d, J= 8,4 Hz, 2H, *CH*ₐᵣₒₘ), 7,42 - 7,29 (m, 3H, C*H*ₐᵣ₋ₒₘ), 7,15 (s, 1H, *CH*ₐᵣₒₘ), 7,09 (dd, J= 8,0, 1,7 Hz, 2H, *CH*ₐᵣₒₘ), 6,97 - 6,84 (m, 3H, *CH*ₐᵣₒₘ), 6,69 (td, *J* = 7,7, 1,5 Hz, 1H, C*H*ₐᵣₒₘ), 6,26 (dd, *J* = 8,0, 1,1 Hz, 1H, C*H*ₐᵣₒₘ), 5,58 (s, 1H, COC*H*), 2,28 (s, 6H, CC*H*₃), 2,25 (s, 6H, CC*H*₃), 2,23 (s, 6H, CC*H*₃), 2,19 (s, 6H, CC*H*₃). ¹⁹⁵Pt NMR (64 MHz, CDCl₃)
δ = -3325,0 (s).

Elementaranalyse berechnet für C₄₅H₄₁N₃O₂Pt: C, 62,76; H, 4,53; N, 5,11; Gefunden: C, 63,05; H, 4,40; N, 4,71.

### Struktur und photophysikalische Charakterisierung

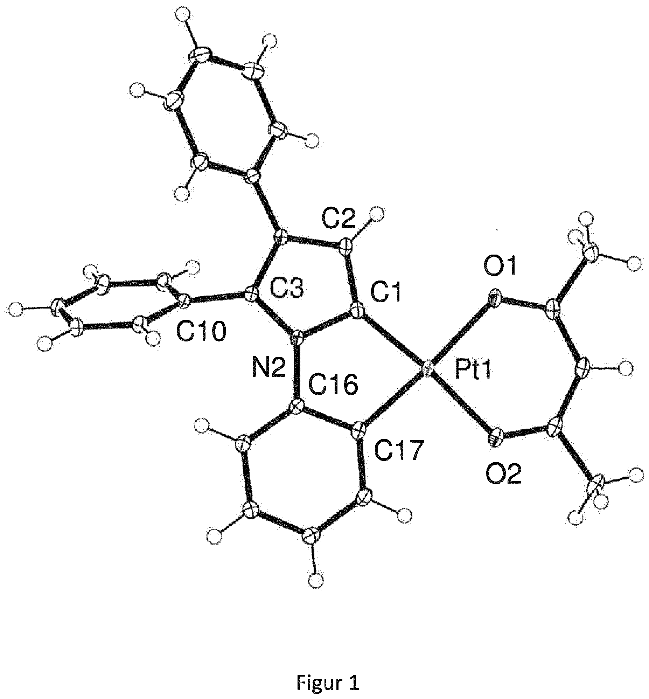

Die Kristallstruktur der Verbindung B ist in Figur 1 wiedergeben. Darin ist die Bindung zwischen dem Carben-Kohlenstoffatom des Imidazolrings (in Figur 1 mit "C1" bezeichnet) und dem Platinatom (in Figur 1 mit "Pt1" bezeichnet) gut zu erkennen.

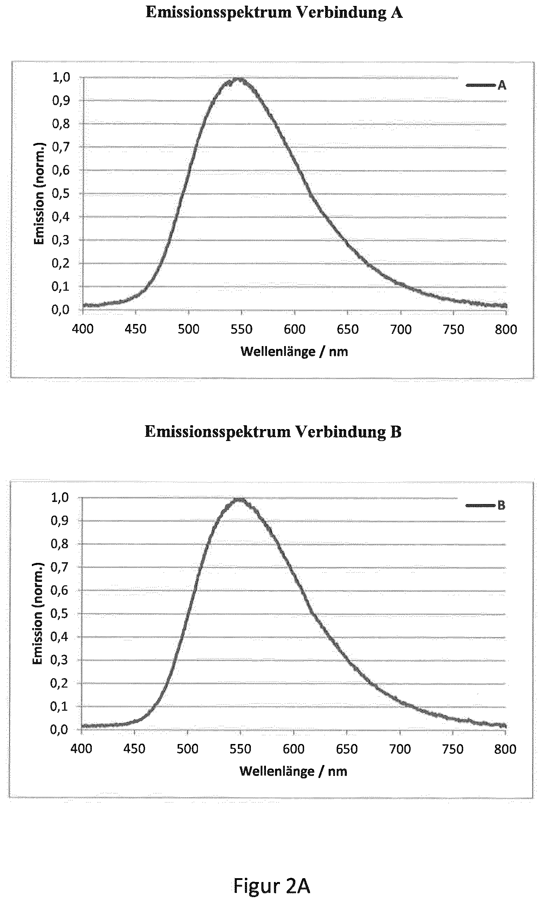

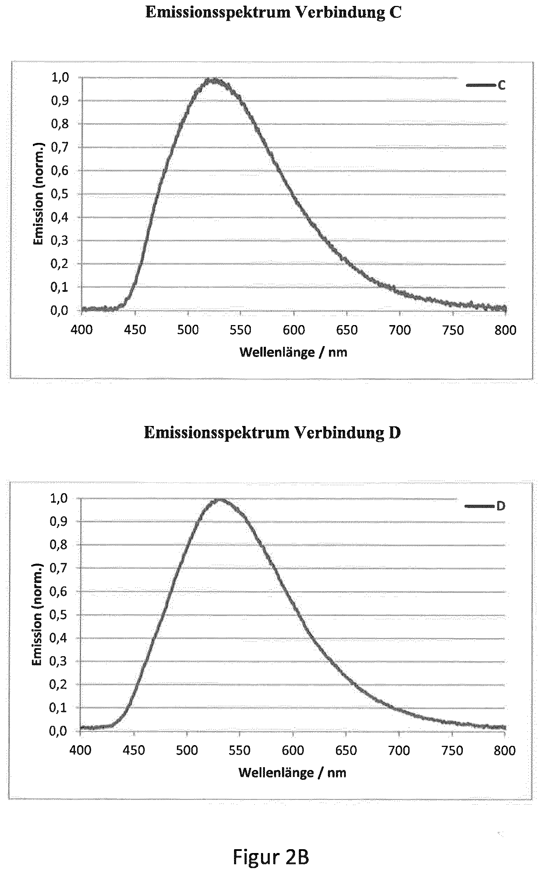

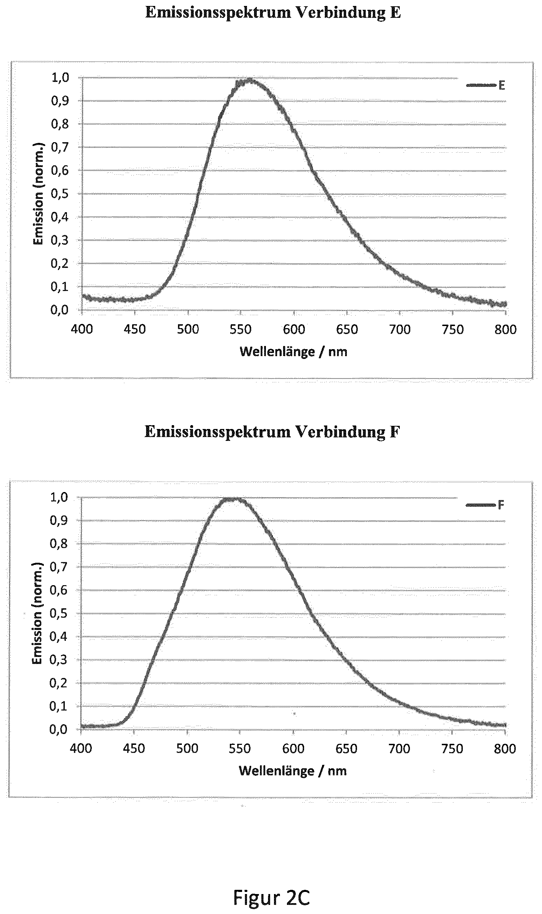

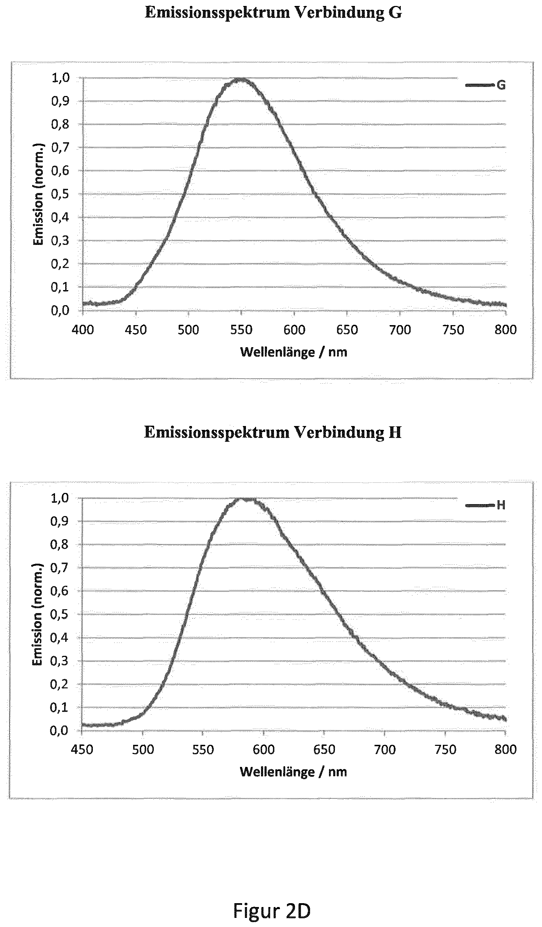

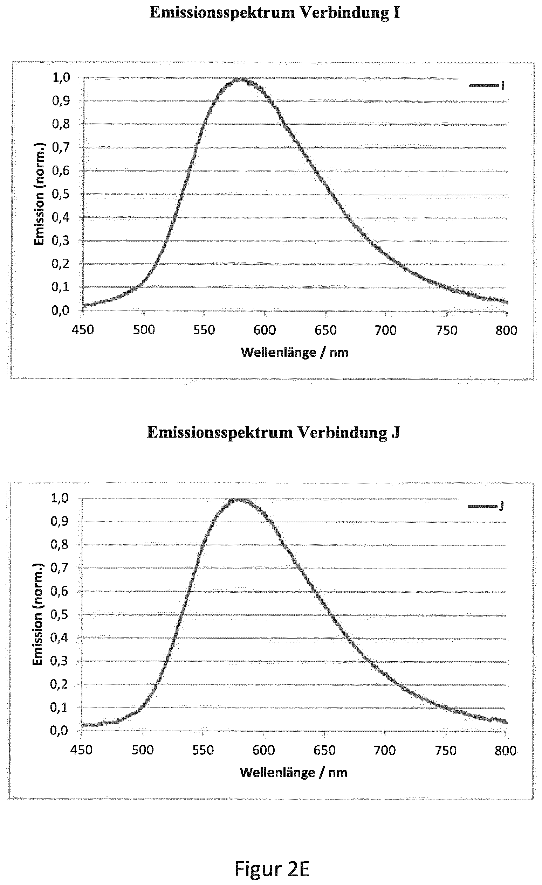

Die Absorptionsspektren für die Verbindungen **A** bis **J** sind in den Figuren 2A bis 2E wiedergegeben. Die Spektren wurden unter Luftatmosphäre in Dichlormethan bei einer Konzentration von 5 ▪ 10-5 mol/l gemessen.

Die Spektren zeigen eine Emission der jeweiligen Verbindung im sichtbaren Bereich und belegen die Eignung für den Einsatz in OLEDs.

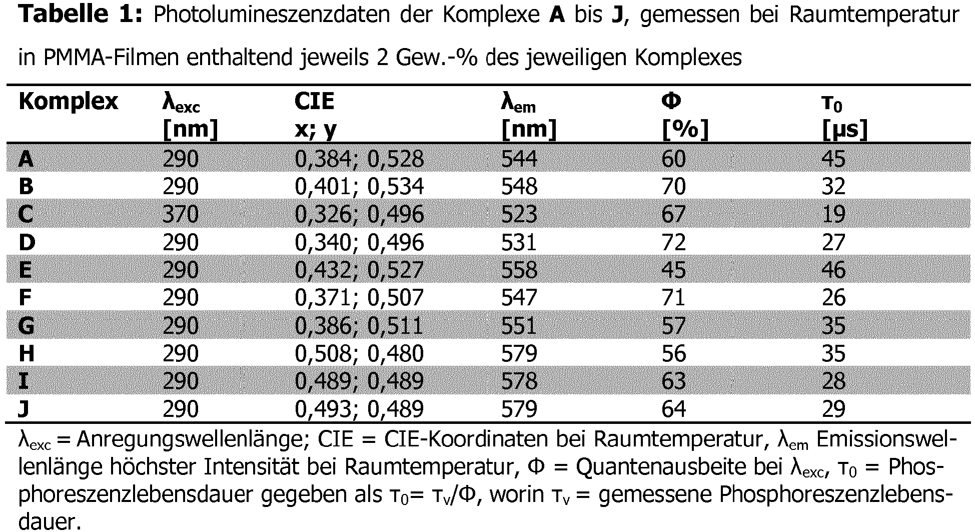

Die Verbindungen weisen deutliche Lumineszenz im grünen bis gelben Bereich des sichtbaren Spektrums mit Emissionswellenlänge λₑₘ höchster Intensität bei Raumtemperatur λₑₘ = 523 nm (Komplex **C**) und 579 nm (Komplexe **H**, **J**) auf.

Weitere photophysikalische Kenndaten der Verbindungen **A** bis **J** können Tabelle 1 entnommen werden.

## Patentansprüche

1. Platin(II)-Komplex der folgenden Formel (I) 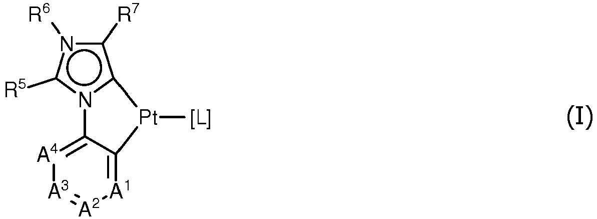 wobei
- A¹ N oder CR¹ ist,
- A² N oder CR² ist,
- A³ N oder CR³ ist,
- A⁴ N oder CR⁴ ist,
wobei R¹ bis R⁴ jeweils unabhängig voneinander ausgewählt sind aus H, einem linearen oder verzweigten, substituierten oder nicht substituierten Alkylrest mit 1 bis 20 Kohlenstoffatomen, in dem gegebenenfalls mindestens ein Kohlenstoffatom durch ein Heteroatom ersetzt ist, einem substituierten oder nicht substituierten Cycloalkylrest mit 3 bis 20 Kohlenstoffatomen, in dem gegebenenfalls mindestens ein Kohlenstoffatom durch ein Heteroatom ersetzt ist, einem substituierten oder nicht substituierten Arylrest mit 6 bis 30 Kohlenstoffatomen, einem substituierten oder nicht substituierten Heteroarylrest mit 5 bis 18 Kohlenstoff- und/oder Heteroatomen, oder einer Gruppe mit Akzeptor- oder Donoreigenschaften,
oder R¹ und R², R² und R³, und/oder R³ und R⁴ gemeinsam mit den Atomen, an die sie gebunden sind, ein kondensiertes aromatisches Ringsystem mit 5 bis 18 Kohlenstoff- und/oder Heteroatomen bilden, wobei das kondensierte aromatische Ringsystem substituiert ist oder nicht substituiert ist,
- R⁵ und R⁶ jeweils unabhängig voneinander ausgewählt sind aus einem linearen oder verzweigten, substituierten oder nicht substituierten Alkylrest mit 1 bis 20 Kohlenstoffatomen, in dem gegebenenfalls mindestens ein Kohlenstoffatom durch ein Heteroatom ersetzt ist, einem substituierten oder nicht substituierten Cycloalkylrest mit 3 bis 20 Kohlenstoffatomen, in dem gegebenenfalls mindestens ein Kohlenstoffatom durch ein Heteroatom ersetzt ist, einem substituierten oder nicht substituierten Arylrest mit 6 bis 30 Kohlenstoffatomen, einem substituierten oder nicht substituierten Heteroarylrest mit 5 bis 18 Kohlenstoff- und/oder Heteroatomen, oder einer Gruppe mit Akzeptor- oder Donoreigenschaften, und
- R⁷ ausgewählt ist aus H, einem linearen oder verzweigten, substituierten oder nicht substituierten Alkylrest mit 1 bis 20 Kohlenstoffatomen, in dem gegebenenfalls mindestens ein Kohlenstoffatom durch ein Heteroatom ersetzt ist, einem substituierten oder nicht substituierten Cycloalkylrest mit 3 bis 20 Kohlenstoffatomen, in dem gegebenenfalls mindestens ein Kohlenstoffatom durch ein Heteroatom ersetzt ist, einem substituierten oder nicht substituierten Arylrest mit 6 bis 30 Kohlenstoffatomen, einem substituierten oder nicht substituierten Heteroarylrest mit 5 bis 18 Kohlenstoff- und/oder Heteroatomen, oder einer Gruppe mit Akzeptor- oder Donoreigenschaften, oder
- R⁵ und R⁶ oder R⁶ und R⁷ gemeinsam mit den Atomen, an die sie gebunden sind, ein kondensiertes aromatisches Ringsystem mit 5 bis 18 Kohlenstoff- und/oder Heteroatomen bilden, wobei das kondensierte aromatische Ringsystem substituiert ist oder nicht substituiert ist,
- oder R⁴ und R⁵ gemeinsam mit den Atomen, an die sie gebunden sind, ein kondensiertes aromatisches Ringsystem mit 6 bis 18 Kohlenstoff- und/oder Heteroatomen bilden, wobei das kondensierte aromatische Ringsystem substituiert ist oder nicht substituiert ist,
- L ein zweizähniger monoanionischer Ligand ist, und
wobei R¹ bis R⁷ und L jeweils gegebenenfalls eine oder mehrere funktionelle Gruppen mit Donor- oder Akzeptoreigenschaften tragen.

2. Platin(II)-Komplex gemäß Anspruch 1, wobei L ein zweizähniger monoanionischer Ligand der Formel (II) 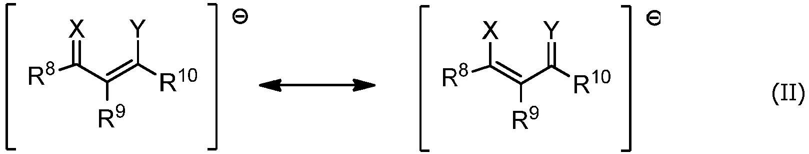 ist, wobei
- X und Y unabhängig voneinander ausgewählt sind aus O, S oder NR¹¹,
- R⁸ und R¹⁰ unabhängig voneinander ausgewählt sind aus einem linearen oder verzweigten, substituierten oder nicht substituierten Alkylrest mit 1 bis 20 Kohlenstoffatomen, in dem gegebenenfalls mindestens ein Kohlenstoffatom durch ein Heteroatom ersetzt ist, einem substituierten oder nicht substituierten Cycloalkylrest mit 3 bis 20 Kohlenstoffatomen, in dem gegebenenfalls mindestens ein Kohlenstoffatom durch ein Heteroatom ersetzt ist, einem substituierten oder nicht substituierten Arylrest mit 6 bis 30 Kohlenstoffatomen, einem substituierten oder nicht substituierten Heteroarylrest mit 5 bis 18 Kohlenstoff- und/oder Heteroatomen,
- R⁹ und R¹¹ unabhängig voneinander ausgewählt sind aus H, einem linearen oder verzweigten, substituierten oder nicht substituierten Alkylrest mit 1 bis 20 Kohlenstoffatomen, in dem gegebenenfalls mindestens ein Kohlenstoffatom durch ein Heteroatom ersetzt ist, einem substituierten oder nicht substituierten Cycloalkylrest mit 3 bis 20 Kohlenstoffatomen, in dem gegebenenfalls mindestens ein Kohlenstoffatom durch ein Heteroatom ersetzt ist, einem substituierten oder nicht substituierten Arylrest mit 6 bis 30 Kohlenstoffatomen, einem substituierten oder nicht substituierten Heteroarylrest mit 5 bis 18 Kohlenstoff- und/oder Heteroatomen, oder
- R⁸ und R⁹, R⁹ und R¹⁰, R⁸ und R¹¹ und/oder R¹⁰ und R¹¹ gemeinsam mit den Atomen, an die sie gebunden sind,
ein kondensiertes aromatisches Ringsystem mit 5 bis 18 Kohlenstoff- und/oder Heteroatomen bilden, wobei das kondensierte aromatische Ringsystem substituiert ist oder nicht substituiert ist, und
wobei
R⁸ bis R¹¹ jeweils gegebenenfalls eine oder mehrere funktionelle Gruppen mit Donor- oder Akzeptoreigenschaften tragen, und wobei, wenn sowohl X als auch Y -NR¹¹ sind, die jeweiligen Reste R¹¹ gleich oder unterschiedlich sind.

3. Platin(II)-Komplex gemäß Anspruch 2, **dadurch gekennzeichnet, dass** X und Y jeweils gleich sind.

4. Platin(II)-Komplex gemäß einem der Ansprüche 1 bis 3, **dadurch gekennzeichnet, dass** A¹ bis A⁴ CR¹ bis CR⁴, wobei mindestens zwei von R¹ bis R⁴ gemeinsam mit den Atomen, an die sie gebunden sind, ein kondensiertes aromatisches Ringsystem bilden.

5. Platin(II)-Komplex gemäß einem der Ansprüche 1 bis 4, **dadurch gekennzeichnet, dass** R⁷ H ist.

6. Platin(II)-Komplex gemäß Anspruch 5, **dadurch gekennzeichnet,**
**dass**
A¹ bis A⁴ jeweils CR¹ bis CR⁴ sind,
R¹, R², R³, R⁴, und R⁹ jeweils H sind,
R⁵ ausgewählt ist aus der Gruppe bestehend aus Phenyl, 4-Bromphenyl, 4-Cyanophenyl,
R⁶ ausgewählt ist aus der Gruppe bestehend aus Methyl oder Phenyl,
R⁸, R¹¹ jeweils unabhängig voneinander ausgewählt sind aus der Gruppe bestehend aus Methyl, tert.-Butyl, Mesityl, Duryl.

7. OLED, enthaltend mindestens einen Platin(II)-Komplex gemäß einem der Ansprüche 1-6.

8. Licht emittierende Schicht, enthaltend mindestens einen Platin(II)-Komplex gemäß einem der Ansprüche 1-6.

9. OLED, enthaltend mindestens eine Licht emittierende Schicht gemäß Anspruch 8.

10. Vorrichtung enthaltend ein OLED und/oder eine Licht emittierende Schicht gemäß einem der Ansprüche 7-9.

11. Verwendung eines Platin(II)-Komplexes gemäß einem der Ansprüche 1-6 in OLEDs.

12. Verwendung gemäß Anspruch 11, **dadurch gekennzeichnet, dass** der Platin(II)-Komplex als Emitter, Matrixmaterial, Ladungstransportmaterial, und/oder Ladungsblocker eingesetzt wird.

## Claims

1. A platinum(ll) complex of the following formula (I) 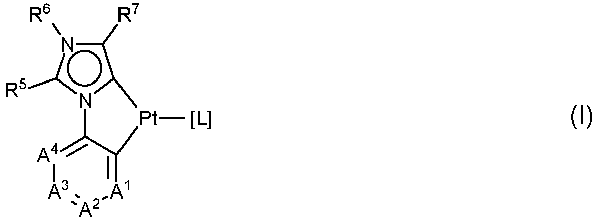 where
- A¹ is N or CR¹,
- A² is N or CR²,
- A³ is N or CR³,
- A⁴ is N or CR⁴,
wherein R¹ to R⁴ are each independently selected from H, a linear or branched, substituted or unsubstituted alkyl radical having 1 to 20 carbon atoms, wherein at least one carbon atom is optionally replaced by a heteroatom, a substituted or unsubstituted cycloalkyl radical having 3 to 20 carbon atoms, in which optionally at least one carbon atom is replaced by a heteroatom, a substituted or unsubstituted aryl radical having 6 to 30 carbon atoms, a substituted or unsubstituted heteroaryl radical having 5 to 18 carbon and/or hetero atoms, or a group having acceptor or donor properties,
or R¹ and R², R² and R³, and/or R³ and R⁴ together with the atoms to which they are attached form a fused aromatic ring system having 5 to 18 carbon and/or hetero atoms, the fused aromatic ring system being substituted or unsubstituted,
- R⁵ and R⁶ are each independently selected from a linear or branched, substituted or unsubstituted alkyl radical having from 1 to 20 carbon atoms, in which optionally at least one carbon atom is replaced by a heteroatom, a substituted or unsubstituted cycloalkyl radical having from 3 to 20 carbon atoms in which optionally at least one carbon atom is replaced by a heteroatom, a substituted or unsubstituted aryl radical having from 6 to 30 carbon atoms, a substituted or unsubstituted heteroaryl radical having from 5 to 18 carbon and/or heteroatoms, or a group having acceptor or donor properties, and
- R⁷ is selected from H, a linear or branched, substituted or non-substituted alkyl radical having from 1 to 20 carbon atoms in which, optionally, at least one carbon atom is replaced by a heteroatom, a substituted or non-substituted cycloalkyl radical having from 3 to 20 carbon atoms in which, optionally, at least one carbon atom is replaced by a heteroatom, a substituted or non-substituted aryl radical having from 6 to 30 carbon atoms, a substituted or non-substituted heteroaryl radical having from 5 to 18 carbon and/or heteroatoms, or a group having acceptor or donor properties, or
- R⁵ and R⁶ or R⁶ and R⁷ together with the atoms to which they are attached form a fused aromatic ring system having 5 to 18 carbon and/or heteroatoms, the fused aromatic ring system being substituted or unsubstituted,
- or R⁴ and R⁵ together with the atoms to which they are attached form a fused aromatic ring system having 6 to 18 carbon and/or heteroatoms, the fused aromatic ring system being substituted or unsubstituted,
- L is a bidentate monoanionic ligand, and
wherein R¹ to R⁷ and L each optionally carry one or more functional groups having donor or acceptor properties.

2. A platinum(II) complex according to claim 1, wherein L is a bidentate monoanionic ligand of formula (II) 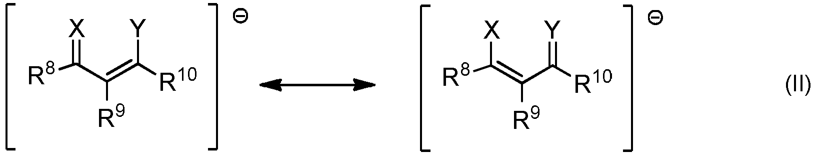 wherein
- X and Y are independently selected from O, S or NR¹¹,
- R⁸ and R¹⁰ are independently selected from a linear or branched, substituted or unsubstituted alkyl radical having 1 to 20 carbon atoms, in which optionally at least one carbon atom is replaced by a heteroatom, a substituted or unsubstituted cycloalkyl radical having 3 to 20 carbon atoms, in which optionally at least one carbon atom is replaced by a heteroatom, a substituted or unsubstituted aryl radical having 6 to 30 carbon atoms, a substituted or unsubstituted heteroaryl radical having 5 to 18 carbon and/or heteroatoms,
- R⁹ and R¹¹ are independently selected from H, a linear or branched, substituted or unsubstituted alkyl radical having from 1 to 20 carbon atoms, in which optionally at least one carbon atom is replaced by a heteroatom, a substituted or unsubstituted cycloalkyl radical having from 3 to 20 carbon atoms, in which optionally at least one carbon atom is replaced by a heteroatom, a substituted or unsubstituted aryl radical having from 6 to 30 carbon atoms, a substituted or unsubstituted heteroaryl radical having from 5 to 18 carbon and/or heteroatoms, or
- R⁸ and R⁹, R⁹ and R¹⁰, R⁸ and R¹¹ and/or R¹⁰ and R¹¹ together with the atoms to which they are attached
form a fused aromatic ring system having 5 to 18 carbon and/or hetero atoms, the fused aromatic ring system being substituted or unsubstituted, and
wherein
R⁸ to R¹¹ each optionally carry one or more functional groups having donor or acceptor properties, and wherein, when both X and Y are -NR¹¹, the respective R¹¹ radicals are the same or different.

3. A platinum(II) complex according to claim 2, **characterized in that** X and Y are each the same.

4. A platinum(II) complex according to any one of claims 1 to 3,
**characterized in that** A¹ to A⁴ are CR¹ to CR⁴, wherein at least two of R¹ to R⁴ together with the atoms to which they are attached form a fused aromatic ring system.

5. Platinum(II) complex according to any one of claims 1 to 4,
**characterized in that** R⁷ is H.

6. Platinum(II) complex according to claim 5,
**characterized in that**
A¹ to A⁴ are CR¹ to CR⁴, respectively,
R¹, R², R³, R⁴ and R⁹ are each H,
R⁵ is selected from the group consisting of phenyl, 4-bromophenyl, 4-cyanophenyl,
R⁶ is selected from the group consisting of methyl or phenyl,
R⁸, R¹¹ are each independently selected from the group consisting of methyl, tert-butyl, mesityl, duryl.

7. OLED comprising at least one platinum(ll) complex according to any one of claims 1-6.

8. A light emitting layer comprising at least one platinum(II) complex according to any one of claims 1-6.

9. OLED comprising at least one light emitting layer according to claim 8.

10. A device comprising an OLED and/or a light emitting layer according to any one of claims 7-9.

11. Use of a platinum(II) complex according to any one of claims 1-6 in OLEDs.

12. Use according to claim 11, **characterized in that** the platinum(ll) complex is used as emitter, matrix material, charge transport material, and/or charge blocker.

## Revendications

1. Complexe de platine(II) selon la formule suivante (I) 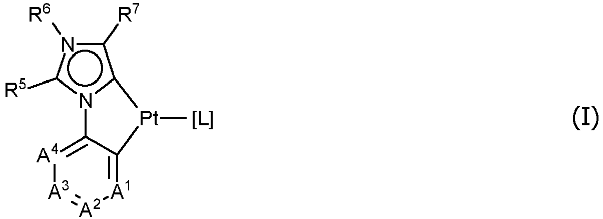 où
- A¹ est N ou CR¹,
- A² est N ou CR²,
- A³ est N ou CR³,
- A⁴ est N ou CR⁴,
où R¹ à R⁴ sont chacun indépendamment choisis parmi H, un radical alkyle linéaire ou ramifié, substitué ou non substitué, ayant 1 à 20 atomes de carbone, dans lequel éventuellement au moins un atome de carbone est remplacé par un hétéroatome, un radical cycloalkyle substitué ou non substitué ayant 3 à 20 atomes de carbone, dans lequel éventuellement au moins un atome de carbone est remplacé par un hétéroatome, un radical aryle substitué ou non substitué ayant 6 à 30 atomes de carbone, un radical hétéroaryle substitué ou non substitué ayant 5 à 18 atomes de carbone et/ou hétéroatomes, ou un groupe ayant des propriétés d'accepteur ou de donneur, ou R¹ et R², R² et R³, et/ou R³ et R⁴ ensemble avec les atomes auxquels ils sont attachés forment un système de cycle aromatique fusionné ayant 5 à 18 atomes de carbone et/ou hétéroatomes, le système de cycle aromatique fusionné étant substitué ou non substitué,
- R⁵ et R sont chacun indépendamment choisis parmi un radical alkyle linéaire ou ramifié, substitué ou non substitué, ayant de 1 à 20 atomes de carbone, dans lequel éventuellement au moins un atome de carbone est remplacé par un hétéroatome, un radical cycloalkyle substitué ou non substitué ayant de 3 à 20 atomes de carbone, dans lequel éventuellement au moins un atome de carbone est remplacé par un hétéroatome, un radical aryle substitué ou non substitué de 6 à 30 atomes de carbone, un radical hétéroaryle substitué ou non substitué de 5 à 18 atomes de carbone et/ou hétéroatomes, ou un groupe ayant des propriétés d'accepteur ou de donneur, et
- R⁷ est choisi parmi H, un radical alkyle linéaire ou ramifié, substitué ou non substitué, ayant de 1 à 20 atomes de carbone, dans lequel éventuellement au moins un atome de carbone est remplacé par un hétéroatome, un radical cycloalkyle substitué ou non substitué ayant de 3 à 20 atomes de carbone, dans lequel éventuellement au moins un atome de carbone est remplacé par un hétéroatome, un radical aryle substitué ou non substitué ayant de 6 à 30 atomes de carbone, un radical hétéroaryle substitué ou non substitué ayant de 5 à 18 atomes de carbone et/ou hétéroatomes, ou un groupe ayant des propriétés d'accepteur ou de donneur, ou
- R⁵ et R⁶ ou R⁶ et R⁷ ensemble avec les atomes auxquels ils sont attachés forment un système de cycle aromatique fusionné ayant 5 à 18 atomes de carbone et/ou hétéroatomes, dans lequel le système de cycle aromatique fusionné est substitué ou non substitué,
- ou R⁴ et R⁵ forment ensemble avec les atomes auxquels ils sont attachés un système de cycle aromatique fusionné ayant 6 à 18 atomes de carbone et/ou hétéroatomes, dans lequel le système de cycle aromatique fusionné est substitué ou non substitué,
- L est un ligand mono-anionique bidenté, et
où R¹ à R⁷ et L portent chacun éventuellement un ou plusieurs groupes fonctionnels ayant des propriétés de donneur ou d'accepteur.

2. Complexe de platine(II) selon la revendication 1, dans lequel L est un ligand mono-anionique bidenté selon la formule (II) 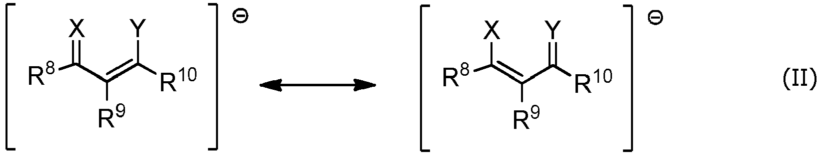 où
- X et Y sont choisis indépendamment parmi O, S ou NR¹¹,
- R⁸ et R¹⁰ sont choisis indépendamment parmi un radical alkyle linéaire ou ramifié, substitué ou non substitué, ayant de 1 à 20 atomes de carbone, dans lequel éventuellement au moins un atome de carbone est remplacé par un hétéroatome, un radical cycloalkyle substitué ou non ayant de 3 à 20 atomes de carbone, dans lequel éventuellement au moins un atome de carbone est remplacé par un hétéroatome, un radical aryle substitué ou non substitué ayant de 6 à 30 atomes de carbone, un radical hétéroaryle substitué ou non substitué ayant de 5 à 18 atomes de carbone et/ou hétéroatomes,
- R⁹ et R¹¹ sont indépendamment choisis parmi H, un radical alkyle linéaire ou ramifié, substitué ou non substitué, ayant 1 à 20 atomes de carbone dans lequel éventuellement au moins un atome de carbone est remplacé par un hétéroatome, un radical cycloalkyle substitué ou non substitué ayant 3 à 20 atomes de carbone dans lequel éventuellement au moins un atome de carbone est remplacé par un hétéroatome, un radical aryle substitué ou non substitué ayant 6 à 30 atomes de carbone, un radical hétéroaryle substitué ou non substitué ayant 5 à 18 atomes de carbone et/ou hétéroatomes, ou
- R⁸ et R⁹, R⁹ et R¹⁰, R⁸ et R¹¹ et/ou R¹⁰ et R¹¹ ensemble avec les atomes auxquels ils sont attachés,
forment un système de cycle aromatique fusionné ayant 5 à 18 atomes de carbone et/ou hétéroatomes, ledit système de cycle aromatique fusionné étant substitué ou non substitué, et
où
R⁸ à R¹¹ portent chacun éventuellement un ou plusieurs groupes fonctionnels ayant des propriétés de donneur ou accepteur, et dans lequel, lorsque X et Y sont tous deux -NR¹¹, les radicaux R¹¹ respectifs sont identiques ou différents.

3. Complexe de platine(II) selon la revendication 2, **caractérisé en ce que** X et Y sont tous deux identiques.

4. Complexe de platine(II) selon l'une quelconque des revendications 1 à 3, **caractérisé en ce que** A¹ à A⁴ sont CR¹ à CR⁴, dans lequel au moins deux des R¹ à R⁴ forment avec les atomes auxquels ils sont attachés un système cyclique aromatique fusionné.

5. Complexe de platine(II) selon l'une quelconque des revendications 1 à 4, **caractérisé en ce que** R⁷ est H.

6. Complexe de platine(II) selon la revendication 5, **caractérisé en ce que**
A¹ à A⁴ respectivement sont CR¹ à CR⁴,
R¹, R², R³, R⁴ et R⁹ sont chacun H,
R⁵ est choisi parmi le groupe constitué par le phényle, le 4-bromophényle, le 4-cyanophényle,
R⁶ est choisi parmi le groupe constitué par le méthyle ou le phényle,
R⁸, R¹¹ sont chacun indépendamment choisis parmi le groupe constitué par le méthyle, le tert-butyle, le mésityle, le duryle.

7. OLED comprenant au moins un complexe de platine(II) selon l'une quelconque des revendications 1 à 6.

8. Couche émettrice de lumière comprenant au moins un complexe de platine(II) selon l'une quelconque des revendications 1 à 6.

9. OLED comprenant au moins une couche émettrice de lumière selon la revendication 8.

10. Dispositif comprenant une OLED et/ou une couche émettrice de lumière selon l'une quelconque des revendications 7 à 9.

11. Utilisation d'un complexe de platine(II) selon l'une quelconque des revendications 1 à 6 dans des OLEDs.

12. Utilisation selon la revendication 11, **caractérisée en ce que** le complexe de platine(II) est utilisé comme émetteur, matériau de matrice, matériau de transport de charge, et/ou bloqueur de charge.
